# EUROPÄISCHE PATENTSCHRIFT

(11) **EP 1 236 220 B1**
(45) Veröffentlichungstag und Bekanntmachung des Hinweises auf die Patenterteilung: **02.01.2013**
(21) Anmeldenummer: 00979638.4
(22) Anmeldetag: 29.11.2000
(51) Int. Cl.: H01J 37/28, H01J 37/244

(54) **DETEKTOR FÜR EIN RASTERELEKTRONENMIKROSKOP MIT VARIABLEM DRUCK UND RASTERELEKTRONENMIKROSKOP MIT EINEM SOLCHEN DETEKTOR**
DETECTOR FOR A SCANNING ELECTRON MICROSCOPE WITH VARIABLE PRESSURE AND A SCANNING ELECTRON MICROSCOPE COMPRISING SUCH A DETECTOR
DETECTEUR POUR MICROSCOPE ELECTRONIQUE A BALAYAGE A PRESSION VARIABLE ET MICROSCOPE ELECTRONIQUE A BALAYAGE COMPRENANT UN TEL DETECTEUR

(30) Priorität: 29.11.1999 DE 19957422
(43) Veröffentlichungstag der Anmeldung: 04.09.2002
(73) Patentinhaber: Carl Zeiss NTS GmbH, 73447 Oberkochen (DE)
(72) Erfinder: ESSERS, Erik, 73430 Aalen (DE)
(74) Vertreter: Gnatzig, Klaus
(86) Internationale Anmeldenummer: PCT/EP2000/011948
(87) Internationale Veröffentlichungsnummer: WO 2001/041180

(56) Entgegenhaltungen:
- WO-A-98/40906
- WO-A-99/27559
- PATENT ABSTRACTS OF JAPAN vol. 015, no. 036 (E-1027), 29. Januar 1991 (1991-01-29) & JP 02 273445 A (NIKON CORP), 7. November 1990 (1990-11-07) in der Anmeldung erwähnt

## Beschreibung

Die Erfindung betrifft einen Detektor für ein Rasterelektronenmikroskop, insbesondere für ein Rasterelektronenmikroskop mit variablem Druck und ein Rasterelektronenmikroskop mit einem solchen Detektor. Unter Rasterelektronenmikroskop mit variablem Druck oder HPSEM ist dabei ein Rasterelektronenmikroskop zu verstehen, bei dem der Betrieb mit Gas in der Probenkammer bei einem Druck von mindestens 0,1 Pa möglich ist. Bei HPSEMs wird als Detektor üblicherweise eine Kollektorelektrode mit nachgeschaltetem Operationsverstärker oder ein Gasszintillationsdetektor verwendet. Letzterer besteht aus einem Lichtleiter mit einem nachgeschalteten Photomultiplier. In beiden Fällen wird eine Sekundärelektronenkaskade im Gas benötigt. Anordnungen, die eine Sekundärlelektronenkaskade ausnutzen, sind beispielsweise in der US 4785182, US 5396067, der US 5677531, der WO 99/27559, in den JP 2236939, JP 2267846 und JP 2273445, sowie im Aufsatz von G. Danilatos in der Zeitschrift Advances in Electronics and Electron Physics, Vol. 78, S 1 - 102, 1990, beschrieben. Im Zusammenhang mit der Sekundärelektronenkaskade treten folgende Probleme auf:
1. Der Verstärkungsfaktor der Sekundärelektronenkaskade wird durch Überschläge begrenzt.
2. Bei den heutigen HPSEMs mit Kollektorelektrode liegt die untere Druckstufenblende auf einem ähnlichen Potential wie die Kollektorelektrode, d.h. die Elektrode am Ende der Sekundärelektronenkaskade. Deshalb muss die Sekundärelektronenkaskade größtenteils auf derselben Wegstrecke im Gas stattfinden, längs der (in umgekehrter Richtung) auch die Primärelektronenstreuung stattfindet. Deshalb können der Druck und die Gasstrecke nicht frei gewählt werden, sondern muss ihr Produkt groß genug sein, um einen ausreichenden Verstärkungsfaktor der Sekundärelektronenkaskade zu erhalten, auch wenn der Druck oder die Gasstrecke sonst eigentlich oft gar nicht so groß sein müssten. Dementsprechend muss unter diesen Bedingungen eine unnötig starke Primärelektronenstreuung in Kauf genommen werden. Dieser Nachteil tritt auch bei einer Detektion im Strahlführungsrohr auf.
3. Bei HPSEMs mit Kollektorelektrode und nachgeschaltetem Operationsverstärker sind keine hohen Rastergeschwindigkeiten möglich. Bei niedrigen Strahlstromstärken sind nicht einmal normale Rastergeschwindigkeiten möglich, wie sie für das Alignment erforderlich sind. Der Grund hierfür liegt darin, dass die Zeitkonstante des Operationsverstärkers bei einem zu hohen Verstärkungsfaktor des Operationsverstärkers zu groß für diese Rastergeschwindigkeiten wird.
4. Sowohl bei HPSEMs mit Gasszintillationsdetektoren als auch bei HPSEMs mit Kollektorelektrode ist die Effizienz des Detektionssystems nicht voll befriedigend. Ein verschlechtertes Signal-zu-Rausch-Verhältnis und eine größere Strahlenschädigung für die Präparate sind die Folgen, an denen die Durchführung mancher Aufgabenstellung scheitert.

Ziel der vorliegenden Erfindung ist es, einen verbesserten Detektor für HPSEMs anzugeben, bei dem mindestens ein Teil der oben genannten Probleme beseitigt ist. Ziel der Erfindung ist es weiterhin, ein HPSEM mit einem solchen verbesserten Detektor anzugeben. Diese Ziele werden durch ein Rasterelektronenmikroskop mit den Merkmalen der Ansprüche 1 und 2 und Detektoren mit den Merkmalen der Ansprüche 18 und 19 gelöst. Vorteilhafte Ausführungsformen der Erfindung ergeben sich aus den Merkmalen der abhängigen Ansprüche.

Ein Rasterelektronenmikroskop nach der Erfindung weist wie die bekannten HPSEMs ein Strahlführungsrohr für die Primärelektronen mit einer probenseitigen letzten Druckstufenblende, durch die die Primärelektronen in die Probenkammer eintreten, eine Probenkammer, einen Probenhalter in der Probenkammer und eine erste Elektrode auf, die gegenüber dem Probenhalter und der letzten Druckstufenblende des Strahlführungsrohres auf einem positiven Potential liegt. Die Potentialdifferenz zwischen der Probe und der ersten Elektrode dient zur Beschleunigung von Sekundärelektronen, die aus einer vom Probenhalter aufgenommenen Probe durch die Primärelektronen ausgelöst werden, wobei durch die Stöße dieser beschleunigten Sekundärelektronen mit den umgebenden Gasmolekülen die bekannte Sekundärelektronenkaskade ausgebildet wird, die zu einer Verstärkung des Sekundärelektronenstromes führt.

Als Strahlführungsrohr im Sinne dieser Anmeldung ist dabei der Bereich zwischen der Elektronenquelle und der letzten Druckstufenblende bezeichnet.

Bei einer ersten Ausführungsform der Erfindung ist mindestens eine zweite Elektrode vorgesehen, deren zum Probenhalter zugerichtetes Ende vom Probenhalter weniger beabstandet ist als die erste Elektrode. Diese zweite Elektrode liegt auf einem Potential, das zwischen dem Potential der ersten Elektrode und dem Potential der Probe oder auf dem Potential der Probe liegt.

Bei einer zweiten Ausführungsform der Erfindung ist eine einzige Elektrode mit geringer elektrischer Leitfähigkeit vorgesehen, entlang der sich aufgrund zweier unterschiedlicher angelegter Potentiale wie bei einer Widerstandskette eine Potentialdifferenz einstellt. Durch diese Potentialdifferenz entsteht eine Elektrode mit variierendem Potential entlang ihrer Oberfläche.

Mit Hilfe der zweiten Elektrode oder dem entlang der Elektrode sich ändernden Potential wird die Potentialverteilung zwischen dem Probenhalter und der ersten Elektrode so beeinflusst, dass ein vergrößertes volumen mit hoher aber unterkritischer Ionisationsdichte entsteht.

Durch die Sekundärelektronenkaskade wird im Gas eine räumlich variierende Ionisationsdichte erzeugt, die von der Geometrie und Potentialbeaufschlagung der vorhandenen Elektroden abhängig ist. Wenn lokal eine zu hohe Ionisationsdichte im Gas erzeugt wird, treten Überschläge auf. Neben den Elektronen werden auch die Photonen der Gasszintillation hauptsächlich im Bereich hoher Ionisationsdichte erzeugt.

Das der Erfindung zugrunde liegende Funktionsprinzip besteht darin, ein vergrößertes Volumen mit hoher aber unterkritischer Ionisationsdichte zu erzeugen, um dadurch einen höheren Verstärkungsfaktor für die Sekundärelektronen oder ein stärkeres Photonensignal zu erhalten. Als unterkritisch wird dabei eine Ionisationsdichte bezeichnet, bei der noch keine Überschläge stattfinden.

Der vergrößerte Bereich mit hoher aber unterkritischer Ionisationsdichte ist bei der Erfindung durch Elektroden begrenzt, so dass dieser Bereich ein gegenüber der restlichen Probenkammmer abgegrenzter Bereich ist. Dieses resultiert daraus, dass diese den Bereich begrenzenden Elektroden gleichzeitig zur Erzeugung des vergrößerten Bereichs mit hoher aber unterkritischer Ionisationsdichte dienen.

Ein Teil des Bereiches mit hoher Ionisationsdichte kann dabei auch außerhalb des abgegrenzten Bereichs liegen, beispielsweise in Form einer in den abgegrenzten Bereich eintretenden Sekundärelektronenkaskade. Dabei sollte insgesamt aber trotzdem mindestens die Hälfte des Volumens mit hoher Ionisationsdichte in dem Bereich liegen, der durch die Elektroden von der restlichen Probenkammer abgegrenzt ist.

Der durch die Elektroden abgegrenzte Bereich liegt außerhalb des vom Strahlführungsrohr eingeschlossenen Bereiches, der durch die letzte Druckstufenblende von der Probenkammmer abgegrenzt ist. Dieses hat zwei Vorteile gegenüber einer Anordnung, bei der der vergrößerte Bereich mit hoher aber unterkritischer Ianisationsdichte oberhalb der letzten Druckstufenblende, also im Strahlführungsrohr liegt. Es müssen erstens keine Maßnahmen ergriffen werden, damit die Sekundärelektronen durch die Druckstufenblende gelangen, was insbesondere bei großen Arbeitsabständen und bei kleinen Öffnungsdurchmessern der letzten Druckstufenblende problematisch ist. Vor allem muss aber zweitens oberhalb der letzten Druckstufenblende, also im Strahlführungsrohr, keine hohe Primärelektronenstreuung in Kauf genommen werden, was unausweichlich der Fall ist, wenn in diesem Bereich eine hohe Ionisationsdichte mit einer Sekundärelektronenkaskade erreicht werden soll. Eine Gasstrecke mit hoher Primärelektronenstreuung oberhalb der letzten Druckstufenblende kann im Gegensatz zu einer Gasstrecke unterhalb der letzten Druckstufenblende durch einen kleinen Arbeitsabstand nicht verkürzt werden. Durch die Anordnung des durch die Elektrode abgegrenzten Bereiches außerhalb des Strahlführungsrohres ist bei der Erfindung auch ein Arbeiten mit mittlerer und kleiner Primärenergie mit den damit verbundenen bekannten Vorteilen möglich.

Der Erfindungsgedanke eines vergrößerten Bereiches mit hoher aber unterkritischer Ionisationsdichte, der sich als gegenüber der Probenkammer durch Elektroden abgegrenzter Bereich außerhalb des Strahlführungsrohres befindet, kann auf verschiedene Weisen realisiert werden:

Bei einer Ausführungsform wird das Volumen mit hoher aber unterkritischer Ionisationsdichte senkrecht zur Ausbreitungsrichtung der Sekundärelektronenkaskade vergrößert. Bei einer alternativen Ausführungsform wird das Volumen mit hoher aber unterkritischer Ionisationsdichte in Ausbreitungsrichtung der Sekundärelektronenkaskade vergrößert. Weiterhin sind auch Mischformen möglich, bei denen das Volumen mit hoher aber unterkritischer Ionisationsdichte sowohl senkrecht zur als auch in Ausbreitungsrichtung der Sekundärelektronenkaskade vergrößert wird.

Bei den bekannten HPSEMs mit Kollektorelektrode erreicht die Ionisationsdichte nahe unterhalb der Öffnung der unteren Druckstufenblende ihren Maximalwert. Bei den bekannten HPSEMs mit Gasszintillationsdetektoren erreicht die Ionisationsdichte ihren Maximalwert nahe vor der positiven Elektrode am Ende der Sekundärelektronenkaskade. Durch geeignete Potentialbeaufschlagung von zusätzlichen Elektroden wird gemäß der Erfindung erreicht, dass die Sekundärelektronenkaskade auf ein größeres Volumen verteilt wird, so dass insgesamt höhere Verstärkungsfaktoren bei gleichzeitig unterkritischer Ionisationsdichte erreicht werden. Mit den erfindungsgemäßen Detektoren für HPSEMs und den erfindungsgemäßen Anordnungen kann daher ein wesentlich höherer Verstärkungsfaktor der Sekundärelektronenkaskade und der von ihr erzeugten Photonen erreicht werden, weil die Sekundärelektronenkaskade durch die zweite Elektrode so geformt wird, dass der Bereich mit der höchsten Ionisationsdichte ein viel größeres Volumen einnimmt. Dadurch kann bei gleicher maximaler Ionisationsdichte ein viel größerer Verstärkungsfaktor der Sekundärelektronenkaskade und der von ihr erzeugten Photonen erreicht werden.

Der zweite o.g. Nachteil wird bei dem erfindungsgemäßen Detektor vermieden, weil zwischen dem Bereich nahe unterhalb der unteren Druckstufenblende und der Elektrode am Ende der Sekundärelektronenkaskade eine Sekundärelektronenkaskade mit hohem Verstärkungsfaktor möglich ist und deshalb im Bereich nahe unterhalb der unteren Druckstufenblende noch kein hoher Verstärkungsfaktor der Sekundärelektronenkaskade erreicht zu sein braucht.

Das dritte o.g. Problem wird bei den erfindungsgemäßen Detektoren durch den aufgrund des vergrößerten Volumens mit großer Ionisationsdichte viel höheren erreichbaren Verstärkungsfaktor der Sekundärelektronenkaskade gelöst. Hierdurch ist nur noch eine geringere Verstärkung durch den nachfolgenden Operationsverstärker nötig.

Bei HPSEMs mit Gasszintillationsdetektoren kann durch einen höheren Verstärkungsfaktor der Sekundärelektronenkaskade die Detektionseffizienz verbessert werden. Insofern ist die Erfindung auch für HPSEMs mit Gasszintillationsdetektoren sehr gut geeignet.

Bei einer weiterhin vorteilhaften Ausgestaltung der Erfindung verläuft die zweite Elektrode oder die schwach leitende Elektrode von der ersten Elektrode geneigt in Richtung auf den Probenhalter und bildet an ihrem dem Probenhalter zugerichteten Ende eine Öffnung für einen Durchgriff des von der ersten Elektrode gebildeten Feldes oder des Feldes von Hilfselektroden, das die Sekundärelektronen zur ersten Elektrode leitet.

Vorzugsweise sind zusätzlich weitere Hilfselektroden zur Verbesserung der Leitung der Sekundärelektronen durch die durch das Ende der zweiten Elektrode definierte Öffnung vorgesehen.

Weiterhin vorzugsweise sind die erste und zweite Elektrode rotationssymmetrisch zur optischen Achse des Rasterelektronenmikroskops, d.h. zum Strahlführungsrohr ausgebildet. Dazu kann die erste Elektrode das Strahlführungsrohr ringförmig umgeben und die zweite Elektrode als die erste Elektrode umgebende, konisch auf den Probenhalter zulaufende trichterförmige Elektrode ausgebildet sein. Durch die zur Probe gerichtete Öffnung der zweiten Elektrode findet der Felddurchgriff statt, der die Sekundärelektronen zur ersten Elektrode leitet. Durch die Rotationssymmetrie der Elektrodenanordnung werden negative Einflüsse auf den Primärelektronenstrahl reduziert.

Eine der weiteren Hilfselektroden kann als eine das Stahlführungsrohr rohrförmig umgebende zylindrische Elektrode ausgebildet sein.

Die erste und die zweite Elektrode und/oder die weiteren Hilfselektroden können auch als eine einzige Elektrode mit geringer elektrischer Leitfähigkeit ausgebildet sein, z.B. als Isolator mit einer schwach elektrisch leitenden Beschichtung. Anstelle einer dünnen Beschichtung auf einem Isolator ist auch eine Ausbildung als massive Elektrode aus einem Material mit geringer elektrischer Leitfähigkeit möglich. Aufgrund der geringen Leitfähigkeit der Elektrode stellt sich dann entlang der Elektrode im Sinne einer Spannungsteilerschaltung ein örtlich unterschiedliches Potential ein. Das der Probe zugerichtete Ende dieser schwach leitenden Elektrode bzw. die Kontaktierung an deren Ende entspricht bei dem Ausführungsbeispiel mit separaten ersten und zweiten Elektroden der zweiten Elektrode. Die Stelle, d.h. Kontaktierung der schwach leitenden Elektrode mit dem höchsten Potential entspricht im Ausführungsbeispiel mit separaten ersten und zweiten Elektroden der ersten Elektrode. In Analogie zum Ausführungsbeispiel mit separaten Elektroden liegt deshalb das der Probe zugerichtete Ende der schwach leitenden Elektrode auf einem niedrigeren Potential als die Stelle der schwach leitenden Elektrode mit dem höchsten Potential.

Bei einem weiteren Ausführungsbeispiel der Erfindung ist die schwach leitende Elektrode im Inneren eines zu einer Seite geöffneten Hohlraumes in einem Lichtleiter aufgebracht. Die Stelle der Kontaktierung dieser schwach leitenden Elektrode mit dem höchsten Potential entspricht in ihrer Funktion wiederum der ersten Elektrode. Sie befindet sich im Hohlraum des Lichtleiters in großem Abstand von der probenseitigen Eingangsöffnung. Die Kontaktierung der schwach leitenden Beschichtung in der Nähe der probenseitigen Öffnung des Hohlraumes entspricht in ihrer Funktion der zweiten Elektrode bei der Ausführungsform mit separaten ersten und zweiten Elektroden. Die Kontaktierung der schwach leitenden Beschichtung in der Nähe der probenseitigen Eintrittsöffnung des Hohlraumes kann durch eine Elektrode erfolgen, die auf den Außenflächen des Lichtleiters aufgebracht ist und dort auch als Verspiegelung des Lichtleiters dient.

Der Hohlraum kann konisch oder pyramidenförmig ausgebildet sein, um die Lichtleitung im Lichtleiter zu einem Lichtdetektor zu verbessern.

Es sind jedoch auch andere Formen des Hohlraumes möglich, beispielsweise eine zylindrische Bohrung.

Es ist weiterhin möglich, die schwach leitende Elektrode in einem Bereich in der Nähe der Eintrittsöffnung mit geringerer Schichtdicke auszubilden als in einem von der Eintrittsöffnung entfernteren Bereich. Aufgrund der daraus resultierenden geringeren Leitfähigkeit in der Nähe der Eintrittsöffnung resultiert in diesem Bereich eine höhere Feldstärke als in dem von der Eintrittsöffnung entfernteren Bereich.

Die erste Elektrode oder die ihr entsprechende Kontaktierung erstreckt sich in einem Hohlraum eines Lichtleiters vorzugsweise mindestens an zwei gegenüberliegenden Seiten des Hohlraumes über ausgedehnte Strecken im Hohlraum, um die Sekundärelektronenkaskade auf ein möglichst großes Volumen zu verteilen.

Bei einer Ausführungsform der Erfindung bei der das Volumen mit hoher aber unterkritischer Ionisationsdichte in Richtung der Ausbreitungsrichtung der Sekundärelektronenkaskade vergrößert ist, erstrecken sich mehrere Elektroden oder eine einzige, nur schwach elektrisch leitende Elektrode entlang eines langgestreckten Hohl- oder Zwischenraumes in einem Lichtleiter oder angrenzend an einen Lichtleiter. Als langgestreckter Hohl- oder Zwischenraum ist dabei ein Hohl- oder Zwischenraum zu verstehen, dessen Länge größer ist als das Doppelte des größten Durchmessers eines in den Querschnitt des Hohl- oder zwischenraumes einschreibbaren Kreises. In einem eintrittsseitigen Bereich des Hohlraumes sind die Elektroden derart mit Potential beaufschlagt, dass sich ein hoher Verstärkungsfaktor für Sekundärelektronen ergibt. Alternativ können auch vor der Eintrittsöffnung zusätzliche Elektroden vorgesehen und mit einem derartigen Potential beaufschlagt sein, dass sich in diesem eintrittseitigen Bereich ein hoher Verstärkungsfaktor für Sekundärelektronen ergibt. An diesen eintrittsseitigen Bereich schließt sich dann ein zweiter Bereich des Hohl- oder Zwischenraumes an, in dem die Elektroden derart schwach mit unterschiedlichen Potentialen beaufschlagt sind, dass in diesem zweiten Bereich ein deutlich reduzierter Verstärkungsfaktor, vorzugsweise zwischen 0,2-fach und 5-fach, idealer Weise von 1 für Sekundärelektronen resultiert.

Dieser zweite Bereich ist ein langgestreckter Bereich. In ihm tritt zwar keine oder keine starke Verstärkung des Sekundärelektronenstromes auf, aber es wird dafür gesorgt, dass weiterhin eine hohe aber unterkritische Ionisationsdichte erhalten bleibt. Dabei wird die Sekundärelektronenkaskade durch Stöße im Gas und durch die Diffusion der Sekundärelektronen zu den Wänden des Zwischenraumes ständig geschwächt, aber gleichzeitig durch das anliegende Feld wiederum gestärkt. Durch die hohe Ionisationsdichte tritt in diesem Volumenbereich eine starke Gasszintillation auf, die durch einen am Ende des Lichtleiters angeordneten Lichtdetektor nachweisbar ist. Auch diese Detektoranordnung ermöglicht durch ein vergrößertes Volumen mit unterkritischer Ionisationsdichte eine wesentliche Verbesserung der Nachweisempfindlichkeit.

Bei einer solchen Detektoranordnung sollte das Potential der Elektrode oder Elektroden in dem Hohl- oder Zwischenraum stellenweise mindestes 200 V, vorzugsweise größer als 400 V positiv gegenüber der letzten Druckstufenblende des Rasterelektronenmikroskops sein. Auch kann bei einer solchen Detektoranordnung das Potential der Elektrode oder Elektroden in dem Hohl- oder Zwischenraum stellenweise mindestes 600 V positiv gegenüber der die Sekundärelektronen emittierenden Probe sein.

Eine weitere Ausgestaltung besteht in der Kombination mit einem Everhardt-Thornley-Detektor, indem die Stirnfläche des ohnehin vorhandenen Lichtleiters als Szintillator ausgebildet wird und mit einer dünnen leitfähigen Schicht als Kontaktierung versehen wird, die mit Hochspannung beaufschlagbar ist. Mit Hilfe einer weiteren vorgelagerten Gitterelektrode, die diese Hochspannung gegenüber dem Primärelektronenstrahl weitgehend abschirmt, kann die Detektoranordnung auch zur Elektronendetektion im Vakuumbetrieb des Elektronenmikroskops eingesetzt werden.

Während bei den heute üblichen HPSEMs mit Kollektorelektrode im Bereich der Öffnung der unteren Druckstufenblende häufig eine hohe elektrische Feldstärke vorhanden ist, die zu einer starken Krümmung des elektrischen Feldes innerhalb der Druckstufenblendenöffnung führt und die Primärelektronen negativ beeinflusst und zu einer Verschlechterung der Auflösung führt, ist bei den erfindungsgemäßen Detektoren im Bereich der Öffnung der unteren Druckstufenblende nur eine schwächere elektrische Feldstärke erforderlich, so dass dieser nachteilige Effekt verringert wird.

Eine weitere Ausführungsform besteht darin, dass die Achse und/oder die Mittelebene des Hohl- oder Zwischenraumes nicht gerade bzw. nicht eben, sondern gekrümmt ist. Dieses hat erstens den Vorteil, dass sich manche Teilchen, die einen Durchschlag begünstigen können, z.B. Röntgenquanten, nicht weit im Hohlraum ausbreiten können. Zweitens hat dieses den Vorteil, dass hochenergetische Elektronen dem gekrümmten Feldverlauf schlecht folgen können und sie deshalb auch ohne Umlenkung durch Stöße im Gas leichter auf die Wand treffen.

Eine wegen ihrer einfachen Herstellbarkeit bevorzugte Ausführungsform eines solchen Hohlraumes mit gekrümmter Achse ist beispielsweise ein wendelförmiger Hohlraum, bei dem die Wendel aus einem zylindrischen Innenteil herausgearbeitet sein kann, das zusammen mit einem als Außenteil dienenden äußeren Hohlzylinder den wendelförmigen Hohlraum bildet.

Die erste Elektrode, die am Ende der Sekundärelektronenkaskade angeordnet ist, liegt bei einem Ausführungsbeispiel auf einem Potential, das um über 100 V, vorzugsweise über 200 V, positiv gegenüber dem Potential der letzten Druckstufenblende ist. Gleichzeitig kann die erste Elektrode, die am Ende der Sekundärelektronenkaskade angeordnet ist, auf einem Potential liegen, das um mindestens 550 V, vorzugsweise über 600 v positiv gegenüber der Probe ist.

Bei einer Ausführungsform mit einer zweiten Elektrode kann diese zweite Elektrode gegenüber der Probe auf einem Potential von mindestens 100 V liegen.

Weitere vorteilhafte Ausführungsformen und Eigenschaften ergeben sich aus der nachfolgenden Beschreibung der in den Figuren dargestellten Ausführungsbeispiele. Es zeigen:
- Fig. 1: die schematische Darstellung eines erfindungsgemäßen Gasszintillationsdetektors in einer ersten Ausführungsform,
- Fig. 2: die schematische Darstellung eines erfindungsgemäßen HPSEM-Detektors mit einer Kollektorelektrode,
- Fig. 3: eine schematische Darstellung eines erfindungsgemäßen Detektors, bei dem Elektroden verwendet werden, längs deren Oberfläche ein kontinuierlicher Spannungsabfall stattfindet,
- Fig. 4: eine schematische Darstellung eines erfindungsgemäßen Gasszintillationsdetektors, bei dem an die Sekundärelektronenkaskade von mehreren Seiten Lichtleiter angrenzen,
- Fig. 5: eine schematische Darstellung des Detektors aus Fig. 4 in einer zur Figur 4 senkrechten Schnittebene,
- Fig. 6: eine schematische Darstellung des Detektors aus Fig. 4 in einer zu den Figuren 4 und 5 senkrechten Schnittebene,
- Figur 7: einen Schnitt durch ein weiteres Ausführungsbeispiel für einen Gasszintillationsdetektor,
- Figur 8: die schematische Darstellung eines weiteren Gasszintillationsdetektors mit mehreren Hohlräumen für verschiedene Druckbereiche,
- Figur 9: eine schematische Schnittdarstellung eines weiteren Ausführungsbeispiels für einen Gasszintillationsdetektor, bei dem der Abstand gegenüber liegender Hohlraumwände variierbar ist, und
- Figur 10: den Detektor in Figur 9 in einer zu Figur 9 senkrechten Schnittebene.

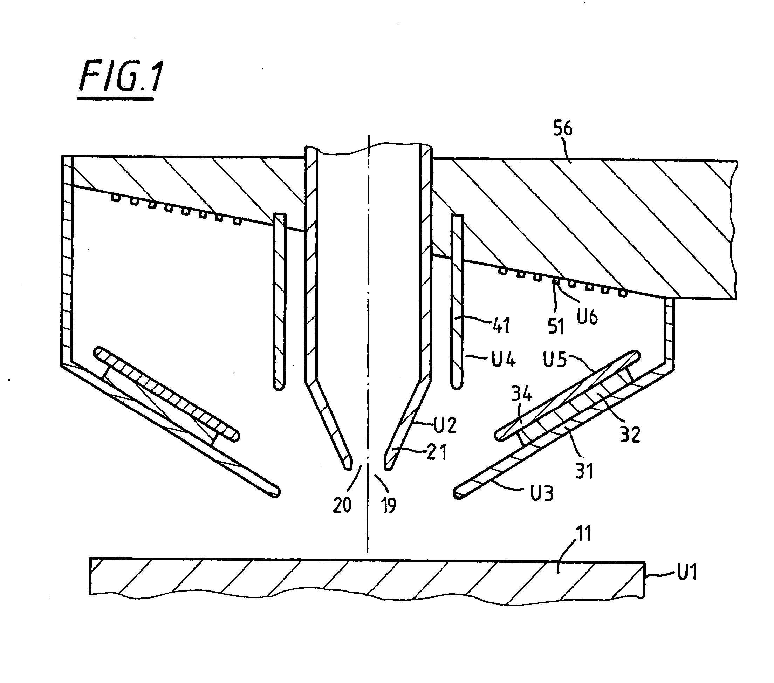

Fig. 1 bis Fig. 10 zeigen schematische Darstellungen erfindungsgemäßer Detektoren für HPSEMs. Die Mikroskopsäule, die Probenkammer, Pumpvorrichtungen, Steuervorrichtungen, etc. sind dabei nicht dargestellt. Ebenso sind die Spannungsquellen zur Erzeugung der Potentiale **U1** bis **U9** und die Operationsverstärker, die an die Kollektorelektroden angeschlossen sind, bzw. die Photomultiplier, die an die Lichtleiter angeschlossen sind, nicht dargestellt.

In Fig. 1 bis Fig. 6 gelangen die Primärelektronen durch die Öffnung **20** der unteren Druckstufenblende **21** des Strahlführungsrohres auf die von einem nicht dargestellten Probenhalter aufgenommene Probe **11,** wo sie Sekundärelektronen erzeugen. Die emittierten Sekundärelektronen und die von ihnen im Gas erzeugten Sekundärelektronen werden im Bereich **19** unterhalb der unteren Druckstufenblende durch das elektrische Feld seitlich abgelenkt und in Richtung zur ersten Elektrode **(50, 51, 52, 67),** die am Ende der Sekundärelektronenkaskade angeordnet ist und zu der das elektrische Feld führt, beschleunigt. Dies führt dazu, dass die Verstärkung durch die Erzeugung von Sekundärelektronen im Gas zu einem großen Teil längs des elektrischen Feldes zwischen dem Bereich **19** und der Elektrode **(50, 51, 52, 67),** die am Ende der Sekundärelektronenkaskade angeordnet ist, stattfindet. Die dabei durch die Sekundärelektronenkaskade erzeugten positiven Ionen folgen dem elektrischen Feld in umgekehrter Richtung und werden in Richtung zum Bereich **19** transportiert.

In Fig. 1 beträgt die bevorzugte Potentialdifferenz zwischen der Probe **11** und der unteren Druckstufenblende **21** je nach Arbeitsabstand, Probe und Gaszusammensetzung beispielsweise bis zu 800 V, bei Verwendung von wasserdampf vorzugsweise zwischen 250 und 450 V. Hierdurch wird eine Sekundärelektronenkaskade zwischen der Probe und der unteren Druckstufenblende erzeugt. Die zweite Elektrode **31,** die die erste Elektrode **51** im wesentlichen trichterförmig mit der Trichterspitze zur Probe **11** umgibt, liegt auf einem Potential, das gegenüber der Druckstufenblende **21** vorzugsweise um 0 bis 150 V positiv ist. Eine weitere Hilfselektrode **34,** die sich parallel zur zweiten Elektrode erstreckt, ist an der Innenseite des Trichters an der zweiten Elektrode **31** über einen Isolator **32** aufgenommen. Eine weitere Hilfselektrode **41** erstreckt sich parallel zum Strahlführungsrohr. Die Potentiale der weiteren Elektroden **41** und **34** sind gegenüber dem Potential der zweiten Elektrode **31** vorzugsweise um bis zu 250 V positiv, jedoch negativ gegenüber der ersten Elektrode **51**. Dadurch findet ein Felddurchgriff des von der ersten Elektrode **51** erzeugten Feldes in den Bereich **19** unterhalb der unteren Druckstufenblende statt, der die Sekundärelektronen durch die von der zweiten Elektrode **31** und der Druckstufenblende **21** gebildeten Öffnung hindurchführt. Die weitere Elektrode **34** ist über eine Isolatorschicht **32** an der zweiten Elektrode **31** befestigt. Die weitere Elektrode **41** kann entweder ebenfalls über eine Isolatorschicht am Strahlführungsrohr mit der Druckstufenblende **21** befestigt sein oder aber (wie in Fig. 1 dargestellt) an einem Lichtleiter **56** befestigt sein. Die erste Elektrode **51** besteht aus mehreren Leiterbahnen oder Drähten, die an der Oberfläche des Lichtleiters **56** befestigt sind und zwischen denen Lücken vorhanden sind, durch die die Photonen in den Lichtleiter eintreten können. Das Potential der ersten Elektrode **51** liegt je nach Detektorgeometrie und Gaszusammensetzung beispielsweise um 100 bis 1000 V - für Wasserdampf als Gas und die in Fig. 1 schematisch dargestellte Geometrie vorzugsweise um 200 bis 500 V - über dem Potential der unteren Druckstufenblende **21.** Insgesamt wird damit zwischen der Probe und der ersten Elektrode **51,** an der die Sekundärelektronenkaskade endet, eine höhere Potentialdifferenz erreicht, als dies bei bekannten HPSEM-Detektoren bei gleichem Gasdruck möglich ist. Die höhere Potentialdifferenz zwischen der Probe **11** und der ersten Elektrode **51** führt zu einem wesentlich höherem Verstärkungsfaktor der Sekundärelektronenkaskade und den damit verbundenen Vorteilen, die oben aufgezählt wurden.

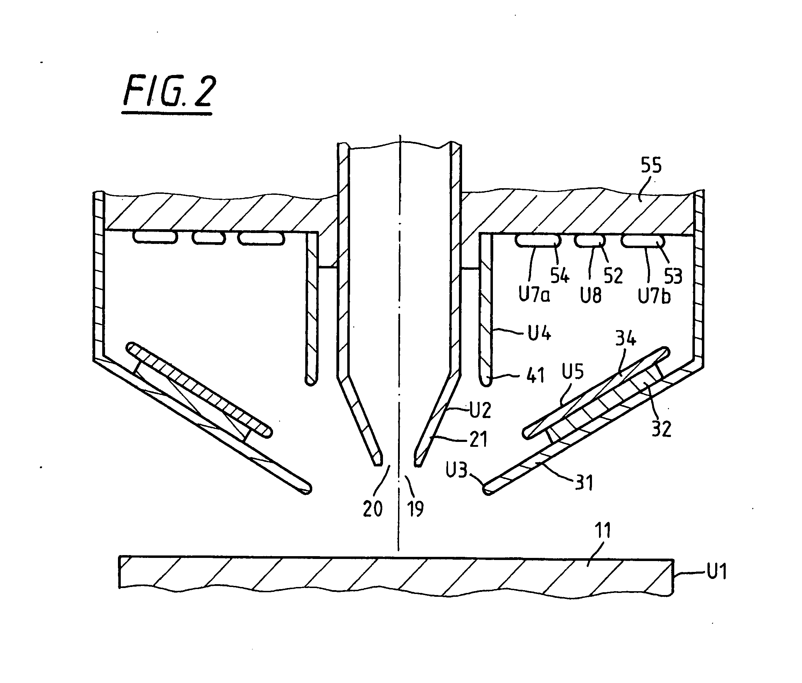

Fig. 2 zeigt die schematische Darstellung eines erfindungsgemäßen HPSEM-Detektors mit Kollektorelektrode. Die bevorzugten Potentialdifferenzen zwischen der Probe **11,** der unteren Druckstufenblende **21,** den Elektroden **31, 41** und **34,** sind dieselben wie bei Fig. 1. In Fig. 2 endet die Sekundärelektronenkaskade an der Kollektorelektrode **52,** die gegenüber der Druckstufenblende **21** je nach Detektorgeometrie und Gaszusammensetzung beispielsweise um 150 bis 1000 V positiv ist und die erste Elektrode darstellt. Für Wasserdampf und die in Fig. 2 dargestellte Geometrie beträgt die Potentialdifferenz bevorzugt zwischen 250 und 500 V. Die weiteren Hilfselektroden **54** und **53** können weggelassen werden, wenn eine einfache Konstruktion gewünscht ist. Der Vorteil bei der Verwendung der Hilfselektroden **53** und **54** besteht im verbesserten Felddurchgriff des Feldes der Kollektorelektrode **52** bis zu der spaltförmigen Öffnung zwischen den anderen Hilfselektroden **34** und **41.** Das Potential der Hilfselektroden **53** und **54** ist dabei für die in Fig. 2 schematisch dargestellte Geometrie bevorzugt zwischen 0 und 100 V negativ gegenüber dem Potential der Kollektorelektrode **52.** Um die Gasstrecke, die die Sekundärelektronenkaskade durchläuft, noch weiter zu vergrößern, kann auch die äußere Hilfselektrode **34** in mehrere Teile unterteilt sein, die dann auf verschiedene Potentiale gelegt werden können und dazu beitragen können, die Sekundärelektronen in Bereiche zu lenken, die noch weiter von der optischen Achse entfernt sind, und in denen dann die Kollektorelektrode angeordnet ist. Dies hat den Vorteil, dass bei gleichem Verstärkungsfaktor der Sekundärelektronenkaskade vor der Kollektorelektrode am Ende der Sekundärelektronenkaskade eine noch geringere Ionisierungsdichte erreicht wird. Dementsprechend ist ein noch höherer Verstärkungsfaktor der Sekundärelektronenkaskade möglich, ohne Überschläge zu erhalten. Die Kollektorelektrode **52,** die Hilfselektroden **53** und **54,** die das Strahlführungsrohr rohrförmig umgebende Elektrode **41** und die die Kollektorelektrode 52 trichterförmig umgebende zweite Elektrode **31** sind in Fig. 2 an dem Isolator **55** befestigt.

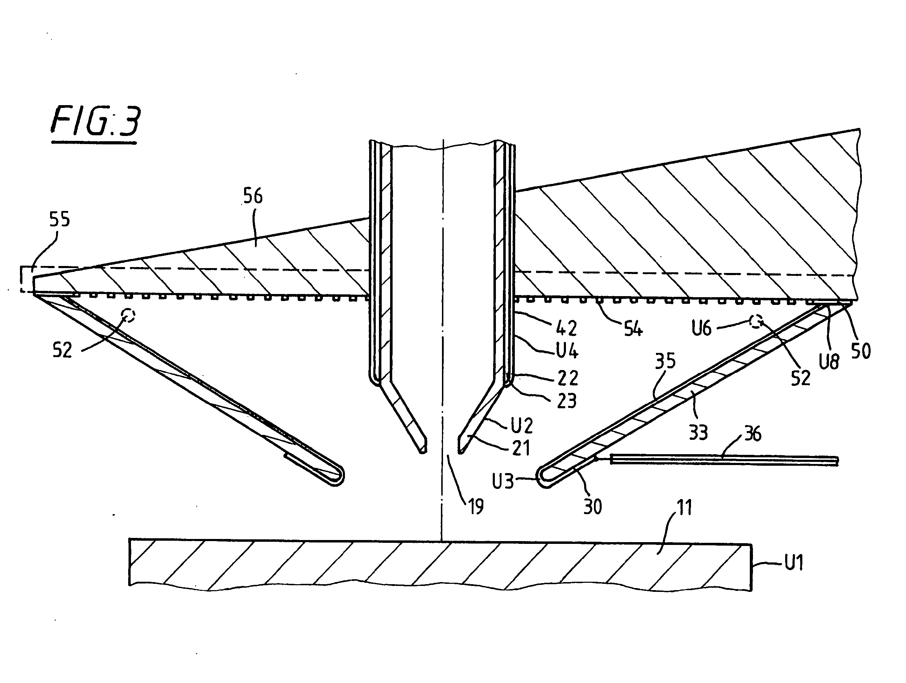

Fig. 3 zeigt eine schematische Darstellung eines weiteren erfindungsgemäßen Detektors für ein HPSEM. Bei Verwendung eines Lichtleiters **56** anstelle des Isolators **55** stellt es einen Gasszintillationsdetektor dar. Bei Verwendung der gestrichelten Kollektorelektrode **52** mit einem nachgeschalteten Operationsverstärker ist es gleichzeitig auch ein Detektor mit Kollektorelektrode. Wenn es ausschließlich als Detektor mit Kollektorelektrode benutzt werden soll, kann der Lichtleiter **56** durch den flachen, gestrichelt gezeichneten Isolator **55** ersetzt werden und dadurch die Bauhöhe verringert werden. Anstelle der zweiten Elektrode **31** in Fig. 1 und Fig. **2** tritt in Fig. **3** der Isolator **33,** dessen Unterseite eine gut leitfähige Schicht **30,** beispielsweise eine Metallschicht, aufweist und der die Funktion der Elektrode **31** übernimmt. Die bevorzugte Potentialdifferenz zwischen der Probe **11** und der Druckstufenblende **21** ist dieselbe wie in Fig. 1 und 2. Die bevorzugte Potentialdifferenz zwischen der Druckstufenblende **21** und der Metallschicht **30** in Fig. 3 ist dieselbe, wie die Potentialdifferenz zwischen der Druckstufenblende **21** und der ersten Elektrode **31** in Fig. 1 und 2.

Auf der Oberseite des Isolators **33** ist eine dünne Schicht **35** dargestellt. Sie weist eine geringe Leitfähigkeit auf und ist an der Grenze zur Metallschicht **30** mit dem Potential U3 der Metallschicht **30** kontaktiert. An ihrem äußeren Rand ist die Schicht **35** durch die Metallschicht **50** kontaktiert, deren Potential dieselbe bevorzugte Größe hat, wie das Potential der Kollektorelektrode **52** in Fig. 2. Hierdurch entsteht längs der dünnen Schicht **35** ein Spannungsabfall. Ein ähnlicher Spannungsabfall entsteht auch an der gegenüberliegenden Wand des Hohlraums längs des Lichtleiters **56** bzw. längs des Isolators **55.** Dies führt dazu, dass die Sekundärelektronenkaskade in einen Bereich geleitet wird, der weit von der optischen Achse entfernt ist und dass die Sekundärelektronenkaskade bei Abwesenheit der Kollektorelektrode **52** schließlich an der Elektrode **50** endet (bzw. an der Kollektorelektrode **52** endet, wenn diese vorhanden ist). Der Vorteil davon, wenn die Sekundärelektronenkaskade in einen weit von der optischen Achse entfernten Bereich geleitet wird, wurde bereits im Zusammenhang mit Fig. 2 genannt. Der Vorteil der Verwendung von Elektroden **(35, 54)** längs denen ein kontinuierlicher Spannungsabfall vorhanden ist, liegt darin, dass es besonders gut gelingt die Sekundärelektronenkaskade in Bereiche zu lenken, die weit von der optischen Achse entfernt sind. Außerdem wird der bauliche Aufwand verringert, weil durch eine solche Elektrode mehrere Elektroden, die auf verschiedenen Potentialen liegen, ersetzt werden können. Die Kontaktierung der Metallschicht **30** mit dem Potential U3 erfolgt über einen isolierten Draht **36,** der bevorzugt ungefähr auf der Äquipotentialfläche von **U3** verläuft, wie sie ohne den Draht vorhanden wäre. Die Funktion der Elektrode **41** aus Fig. 1 und 2 übernimmt in Fig. 3 die gut leitfähige, das Strahlführungsrohr über einen Isolator **23** umgebende Schicht **42,** die beispielsweise eine Metallschicht ist. Ihr Potential liegt bevorzugt zwischen 5 und 250 V über dem Potential der Druckstufenblende **21,** von der sie elektrisch durch die Isolatorschicht **23** getrennt ist. Zwischen der Metallschicht **42** und der Elektrode **21** kann eine dünne Schicht **22** mit geringer Leitfähigkeit aufgebracht sein, längs der der Spannungsabfall zwischen den Potentialen **U2** und **U4** stattfindet. Um den Aufbau zu vereinfachen, können die Metallschicht **42,** Isolator **23** und die Metallschicht **22** auch weggelassen werden, wobei dann allerdings ein nicht ganz so guter Felddurchgriff für das elektrische Feld, das die Sekundärelektronenkaskade von der optischen Achse weglenkt, erreicht wird. Auf der lichtdurchlässigen Unterseite des Lichtleiters **56** ist in dünnen Strukturen, beispielsweise in netzförmigen Bahnen, eine Schicht **54** mit geringer Leitfähigkeit aufgebracht, wobei die Breite der Leiterbahnen weniger als 1 mm beträgt und zwischen den Leiterbahnen Lücken vorhanden sind, durch die die Photonen in den Lichtleiter eintreten können. Diese beispielsweise netzförmige Schicht ist durch die Metallschicht **42** mit dem Potential **U4** kontaktiert und durch die Metallschicht **50** mit dem Potential **U8** kontaktiert, so dass längs dieser Schicht ein Spannungsabfall anliegt, ähnlich wie bei der die zweite Elektroden bildenden Schicht **35.** Eine besonders vorteilhafte Ausgestaltung besteht darin, dass die Schicht **54** für die bei der Gasszintillation erzeugten Photonen transparent ist. In diesem Fall sind auch keine Lücken innerhalb der Schicht erforderlich. Wenn der Isolator **55** statt des Lichtleiters **56** verwendet wird, wird die Schicht **54,** längs der der Spannungsabfall stattfindet, ebenfalls ohne Lücken ausgeführt, um einen möglichst geringen Herstellungsaufwand zu erreichen. In diesem Fall muss die Schicht auch nicht transparent sein.

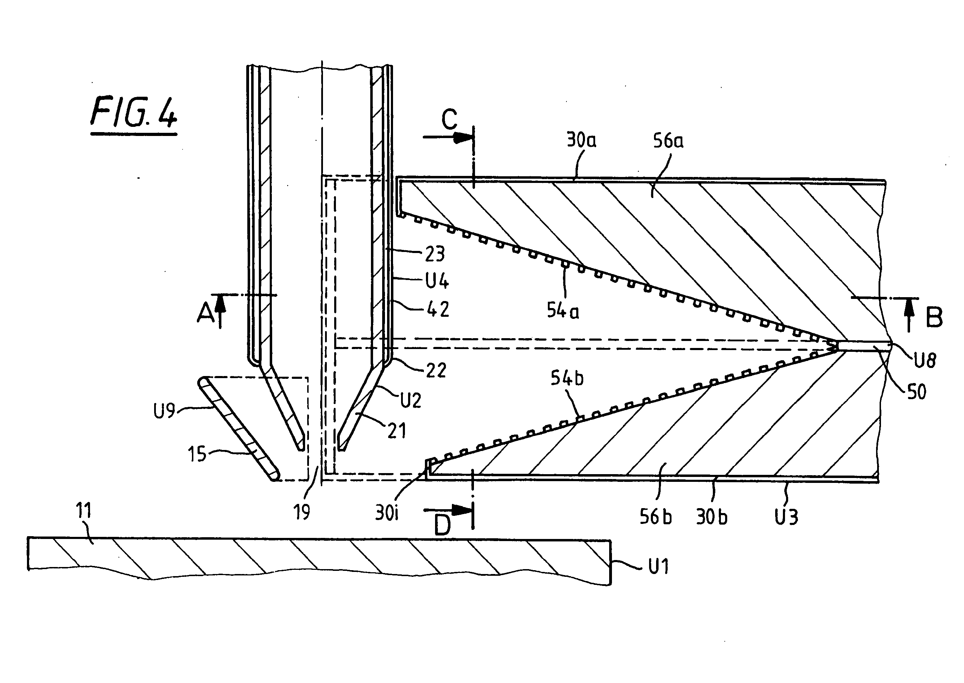

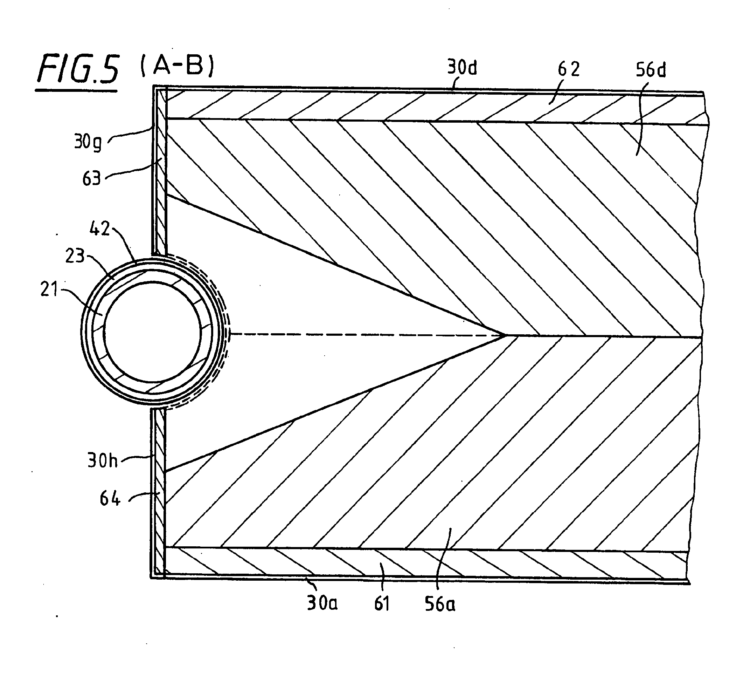

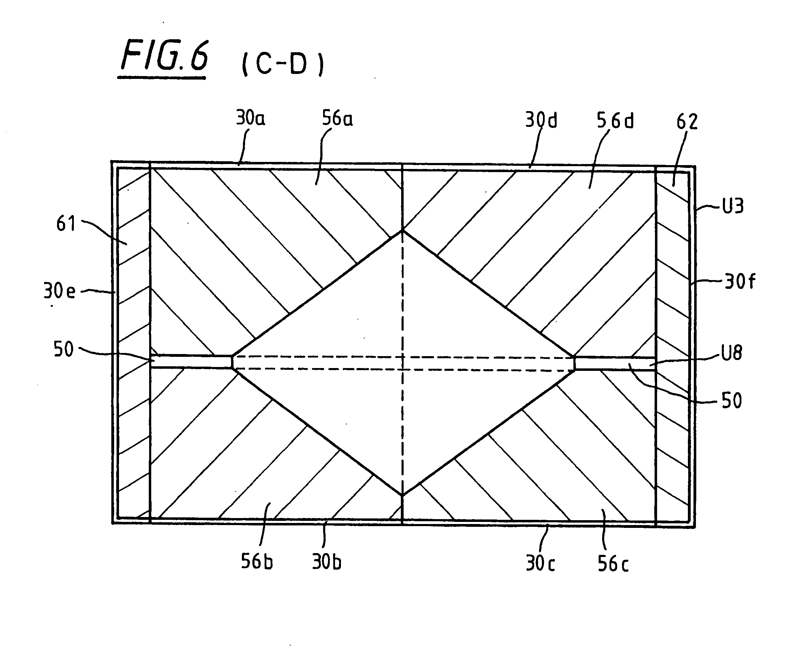

Fig. 4, Fig. 5 und Fig. 6 zeigen in verschiedenen Schnittebenen eine schematische Darstellung eines weiteren erfindungsgemäßen Gasszintillationsdetektors. In Fig. 4 ist dabei der Verlauf der Schnittebenen von Fig. 5 und Fig. 6 eingezeichnet. Die Teile der Lichtleiter, der Isolatorschicht **64** und der Elektroden **15, 30** und **50,** die hinter der Zeichenebene liegen, sind in Fig. 4 gestrichelt dargestellt. Der Lichtleiter **56** ist in vier Teile **56a, 56b, 56c** und **56d** unterteilt. Diese bilden einen pyramidenförmigen Hohlraum, in den in Fig. 6 von der Grundfläche der Pyramide aus hineingeschaut wird. Die Wände dieses Hohlraums werden von lichtdurchlässigen Oberflächen der Lichtleiter gebildet, auf denen wie in Fig. 3 Schichten **(54a, 54b, 54c, 54d)** mit geringer Leitfähigkeit aufgebracht sind, längs denen ein Spannungsabfall stattfindet. Wie in Fig. 3 sind auch hier diese Schichten entweder so strukturiert, dass Lücken vorhanden sind, durch die die Photonen in den Lichtleiter eintreten können oder sie sind transparent, so dass die Photonen die Schichten selbst durchdringen können. Wie in Fig. 5 und Fig. 6 zu erkennen ist, sind außen um den Lichtleiter zusätzliche Isolatoren **(61, 62, 63** und **64)** angebracht. Der Lichtleiter und die Isolatoren werden von einer mehrteiligen Elektrode **30** (bestehend aus **30a, 30b, 30c, 30d, 30e, 30f, 30g, 30h, 30i)** umschlossen, die auf dem Potential **U3** liegt. Durch diese Elektrode sind auch die auf den inneren Oberflächen des Lichtleiters aufgebrachten Schichten **54a** bis **54d** kontaktiert. Auf der anderen Seite sind die auf den inneren Oberflächen des Lichtleiters aufgebrachten Schichten **54a** bis **54d** durch die Elektrode **50** kontaktiert, die auf dem Potential **U8** liegt und die auf der gesamten Begrenzungsfläche zwischen den Lichtleitern **56a** und **56b** bzw. **56c** und **56d** angeordnet ist. Diese Elektrode entspricht in ihrer Funktion der Elektrode **50** in Fig. 3. An ihr endet die Sekundärelektronenkaskade..Wie in Fig. 5 zu erkennen ist, erstrecken sich die Lichtleiter von der optischen Achse aus gesehen nur nach einer Seite statt nach beiden Seiten, wie dieses bei den Ausführungsformen in Fig. 1 und Fig. 3 der Fall ist.

Im Gegensatz zu den in Fig. 1 bis Fig. 3 dargestellten Aufbauten, sind bei dem Aufbau aus Fig. 4 bis Fig. 6 die Elektroden im Bereich zwischen der Probe 11 und unteren Druckstufenblende 21 nicht rotationssymmetrisch. Die Lichtleiter **56b** und **56c** haben einen halbkreisförmigen Ausschnitt um die optische Achse herum. Dadurch wird zwischen ihnen und der unteren Druckstufenblende **21** eine Öffnung gebildet, durch die Teile der Sekundärelektronenkaskade in den pyramidenförmigen Hohlraum eintreten können. Dies wird dadurch gefördert, dass die den Lichtleiter umgebende Elektrode **30** (auch **30i)** gegenüber der Druckstufenblende **21** auf einem je nach Vergrößerung, Primärenergie und Arbeitsabstand zwischen 0 und 500 V, bevorzugt zwischen 0 und 200 V, höheren Potential liegt. Dieses einseitig wirkende elektrische Feld hätte einen negativen Einfluß auf die erreichbare Auflösung. Wenn eine hohe Auflösung erreicht werden soll, kann deshalb eine dem Lichtleiter bezüglich der optischen Achse des Rasterelektronenmikroskops gegenüber liegende Kompensationselektrode **15** mit einem Potential **U9** beaufschlagt werden, das so gewählt ist, dass im Bereich der optischen Achse das elektrische Feld in Richtung zur Kompensationselektrode **15** und das elektrische Feld in Richtung zum Lichtleiter **56** ungefähr ausgeglichen sind. Die Kompensationselektrode **15** hat dabei die Form des Segmentes eines Hohlkegelstumpfes, dessen Umriss in Fig. 4 gestrichelt dargestellt ist. Dadurch kann die Probe bei dem in Fig. 5 bis Fig. 6 dargestellten Aufbau sehr gut in Richtung der Elektrode **15** verkippt werden. Durch eine Veränderung des Potentials **U9** kann dabei auch der Auflösungsverschlechterung entgegen gewirkt werden, die durch die anliegende Spannung zwischen der Probe 11 und der unteren Druckstufenblende **21** sonst bei verkippter Probe auftreten würde. Die untere Druckstufenblende **21** liegt auf einem Potential, das je nach Gaszusammensetzung, Arbeitsabstand und Probe gewählt wird und für Wasserdampf bevorzugt zwischen 0 und 500 V über dem Probenpotential liegt. Die aus mehreren Teilelektroden bestehende, den Lichtleiter außen umgebende Elektrode **30** liegt gegenüber der unteren Druckstufenblende **21** auf einem Potential, das für die dargestellte Detektorgeometrie zwischen 0 und 500 V, bevorzugt zwischen 0 und 200 V, positiv ist, bei anderer Detektorgeometrie jedoch auch noch größer sein kann. Wie in Fig. 3, ist auch in Fig. 4 bis 6 eine zusätzliche, das Strahlführungsrohr umgebende Elektrode **42** vorgesehen, die aus einer Metallschicht besteht und durch eine Isolatorschicht **23** gegenüber der Druckstufenblende **21** elektrisch isoliert ist. Ihr Potential **U4** ist für die dargestellte Detektorgeometrie ebenfalls bevorzugt um 0 bis 200 V positiv gegenüber der Druckstufenblende **21.** Eine konstruktive vereinfachung erhält man, indem das Potential U4 der das Strahlführungsrohr umgebenden Elektrode **42** auf dasselbe Potential **U3** gelegt wird, wie die die Lichtleiter außen umgebende Elektrode **30.** Wie in Fig. 3, kann auch in dem Aufbau aus Fig. 4 eine dünne Schicht 22 mit geringer Leitfähigkeit und einem kontinuierlichen Spannungsabfall zwischen der Elektrode **21** und der das Strahlführungsrohr umgebenden Elektrode **42** vorgesehen werden, um den Feldverlauf noch weiter zu verbessern und den Isolator **23** zu verdecken. Bei geringer Potentialdifferenz zwischen der unteren Druckstufenblende **21** und der die Lichtleiter umgebenden Elektrode **30** wird als bevorzugte Ausführungsform eine konstruktive Vereinfachung dadurch erreicht, dass die das Strahlführungsrohr umgebende Elektrode **42,** die Isolatorschicht **23** und die dünne Schicht **22** weggelassen werden.

Insgesamt ist die Funktionsweise des in Fig. 4 bis 6 dargestellten Aufbaus ähnlich zu der des in Fig. 3 dargestellten Aufbaus. Zwischen der Probe **11** und der unteren Druckstufenblende **21** wird eine Sekundärelektronenkaskade erzeugt. Weil später eine weitere Verstärkung des Sekundärelektronenstromes im pyramidenförmigen Hohlraum stattfindet, genügt hier im Gegensatz zu den heute bekannten Detektoren für HPSEMs eine schwache Sekundärelektronenkaskade. Je nach Einstellung der Potentiale **U9, U3, U2** und **U1** kann entweder der Großteil der Sekundärelektronenkaskade nach rechts oben in den pyramidenförmigen Hohlraum gelenkt werden, wobei allerdings je nach Primärenergie und Potentialdifferenzen nicht die volle Ortsauflösung des Mikroskops erreicht werden kann, oder es kann in Fig. 4 die rechte Hälfte der Sekundärelektronenkaskade in den pyramidenförmigen Hohlraum gelenkt werden und die volle Auflösung des Mikroskops erreicht werden. In dem pyramidenförmigen Hohlraum erstreckt sich die Sekundärelektronenkaskade nach allen Seiten hin zur ersten Elektrode 50, die auf dem Potential **U8** liegt. Das Potential **U8** liegt dabei je nach Gaszusammensetzung und Detektorgeometrie beispielsweise zwischen 100 V und über 1000 V (für die schematisch dargestellte Geometrie und Wasserdampf als Gas bevorzugt zwischen 100 V und 600 V) über dem Potential **U2** der unteren Druckstufenblende. Die Erzeugung der Sekundärelektronenkaskade in dem pyramidenförmigen Hohlraum, der von Lichtleitern umschlossen ist, hat den Vorteil, dass ein sehr großer Anteil der durch Gasszintillation erzeugten Photonen in den Lichtleiter gelangt. Dieses kann alternativ mit geringerem Bauraum und geringerer Querschnittsfläche des Lichtleiters auch erreicht werden, indem die Lichtleiterflächen durch isolierende spiegelnde Flächen ersetzt werden, auf die die schlecht leitfähige Schicht aufgebracht wird. Eine isolierende spiegelnde Fläche kann auch aus einem dünnen Lichtleiter, der von hinten verspiegelt ist, bestehen. Die Pyramidenform des Hohlraums hat den Vorteil, dass auf der Lichtleiteroberfläche besonders leicht Strukturen aus der schicht mit geringer Leitfähigkeit aufgebracht werden können, weil die Begrenzungsflächen des Hohlraums eben sind. Selbstverständlich sind aber auch andere Formen für den Hohlraum möglich, die keine ebenen Begrenzungsflächen haben und hinsichtlich des elektrischen Feldes teilweise sogar noch günstiger sind.

In Fig. 1 bis Fig. 4 ist die durch die zweite Elektrode 31 bzw. 30 bzw. **30i** gebildete Öffnung, durch die die Sekundärelektronen gelangen, relativ groß. Sie kann aber auch wesentlich kleiner (beispielsweise ähnlich groß wie die Öffnung der Druckstufenblende) sein oder durch mehrere kleinere Öffnungen, die seitlich von der Druckstufenblende angeordnet sind, ersetzt werden. Der Vorteil besteht dabei darin, dass es möglich wird, für die Sekundärelektronenkaskade ein anderes Gas mit wesentlich höherem Verstärkungsfaktor zu verwenden als es in der Probenkammer vorhanden ist. Um den Austausch mit dem Gas in der Probenkammer möglichst gering zu halten, ist es vorteilhaft, in der Probenkammer und in dem Hohlraum, in dem die Sekundärelektronenkaskade stattfindet, denselben Druck zu haben. Der Hohlraum, in dem die Sekundärelektronenkaskade stattfindet, kann dabei mit dem für die Sekundärelektronenkaskade gewünschten Gas gespült werden, um die Verunreinigung durch das Gas aus der Probenkammer möglichst gering zu halten. Eine noch geringere Verunreinigung durch das Gas aus der Probenkammer erhält man, wenn der Gasdruck in dem Hohlraum höher gehalten wird als in der Probenkammer. Mit einem solchen erfindungsgemäßen Detektor, der mit einer Sekundärelektronenkaskade arbeitet, ist auch der Betrieb nahezu ohne Gas in der Probenkammer möglich, bei dem die Probenkammer ständig evakuiert wird und das in der Probenkammer vorhandene Gas nur aus dem Gas besteht, das durch die Öffnungen aus dem Hohlraum nachströmt, in dem die Sekundärelektronenkaskade stattfindet.

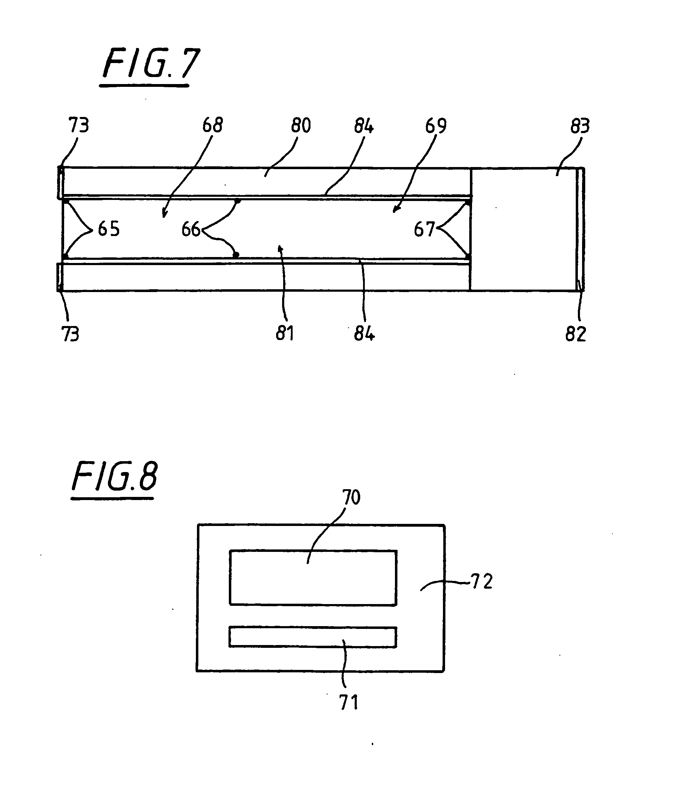

Der Gasszitillationsdetektor in Figur 7 besteht aus einem zylindrischen Rohr **80** aus einem Licht leitenden Material mit einem Lichtdetektor **82** am Ende des Lichtleiters **83,** der sich an das zylindrische Rohr anschließt. Der zu einer Seite offene Hohlraum im Lichtleiter weist eine elektrisch schwach leitende Beschichtung **84** auf. Über geeignete Potentialbeaufschlagungen der Kontaktierungsringe **65,66,67** wird erreicht, dass im eintrittsseitigen Bereich **68** des Rohrinnenraumes 81 ein Bereich mit höherer elektrischer Feldstärke entsteht, in dem eine starke Sekundärelektronenkaskade auftritt. Die Ionisationsdichte in diesem Bereich wird idealer Weise bis nahe an die Durchschlags-Ionisationdichte geführt. An diesen eintrittsseitigen Bereich schließt sich ein im Vergleich zum größten Durchmesser eines in den Querschnitt einschreibbaren Kreises langer Bereich **69** an, in dem durch geeignete Potentialbeaufschlagung der Kontaktierungen **66, 67** eine geringere elektrische Feldstärke vorherrscht, so dass in diesem Bereich eine Sekundärlektronenvervielfachung von etwa 1 auftritt, also der Sekundärelektronenstrom ohne wesentliche weitere Verstärkung konstant gehalten wird. In diesem langgestreckten zweiten Bereich tritt aufgrund der großen Ionisationsdichte über einen langen Bereich eine starke Gasszintillation auf, ohne dass eine überkritische, zum Durchbruch führende Ionisationsdichte erforderlich ist. Durch Nachweis der im zweiten Bereich erzeugten Photonen ist ein sehr empfindlicher Nachweis der ursprünglichen Sekundärelektronen möglich.

Die mittlere Kontaktierung 66 kann auch entfallen, wenn stattdessen im ersten Bereich eine zur Feldstärke im zweiten Bereich unterschiedliche Feldstärke dadurch eingestellt wird, dass sich die Leitfähigkeit der schwach leitfähigen Beschichtung im ersten Bereich von der im zweiten Bereich unterscheidet. Dieses kann beispielsweise durch eine unterschiedliche Schichtdicke in beiden Bereichen erreicht werden.

Eine weitere vorteilhafte Möglichkeit besteht darin, die eintrittseitige Erzeugung der Sekundärelektronenkaskade mit einer hohen Ionisationsdichte nicht innerhalb des Hohlraumes sondern vor dem Hohlraum stattfinden zu lassen. Dieses ist mit Hilfe einer weiteren Elektrode **73** an der Stirnseite des Detektors einstellbar, die ebenfalls als elektrisch schwach leitende Beschichtung ausgebildet sein kann, so dass sich ein Gradient des elektrischen Feldes in Richtung der Öffnung des Hohlraumes einstellt.

Die Verspiegelung der äußeren Flächen der Lichtleiter **80, 83** ist in Figur 7 nicht dargestellt. An der Stirnfläche **73** ist auch eine lichtdurchlässige, leitfähige oder schwach leitfähige Beschichtung vorteilhaft.

An dieser Stelle sei darauf hingewiesen, dass der Hohlraum nicht zwingend zylindrisch rund zu sein braucht, vielmehr sind auch zylindrische Hohlräume mit planen oder unterschiedlich gekrümmten Wänden denkbar. Statt eines Hohlraumes kann auch ein Spalt verwendet werden, dessen wirksame Höhe durch den größten Durchmesser eines in den Spalt einschreibbaren Kreises gegeben ist. Die Kontaktierung darf dabei jedoch nicht über die gesamte Spaltbreite erfolgen, sondern insbesondere diejenige Kontaktierung, an der das höchste Potential anliegt, sollte einen ausreichenden Abstand von den Rändern des Spaltes aufweisen, damit keine Überschläge auftreten. Wenn ein Spalt oder Zwischenraum anstelle eines Hohlraumes verwendet wird, sollte die Spalt- bzw. Zwischenraumbreite mehr als dreimal so groß gewählt werden wie die wirksame Höhe des Spaltes bzw. Zwischenraumes, damit solche Überschläge nicht auftreten.

In einer Weiterführung der Erfindung ist es auch möglich, mehrere Hohl- oder Zwischenräume mit zumindest in einer Richtung unterschiedlichen Abständen gegenüberliegender Wandflächen vorzusehen. Eine Aufsicht auf eine solche Weiterbildung ist in Figur 8 dargestellt. Eine bevorzugte Ausführungsform besteht darin, dass der Hohlraum **71** mit dem kleineren Abstand gegenüber liegender Wände näher an die Probe heran reicht, als der Hohlraum mit dem größeren Abstand gegenüber liegender Wände. Durch die unterschiedlichen Abmessungen der Hohlräume **70, 71** in einem Lichtleiter **72** mindestens in einer Richtung senkrecht zur Längsachse der Hohlräume ist jeweils einer der Hohlräume **(70,71)** bei gleichen angelegten Potentialen für eine nahezu optimale Sekundärelektronenkaskade bei unterschiedlichen Drücken prädestiniert. Je nach jeweiligem Kammerdruck kann dann einer der Hohlräume als Sekundärelektronendetektor ausgewählt werden, indem die Elektrode oder Elektroden in einem der beiden Hohlräume mit dem die Sekundärelektronenkaskade ausbildenden Potential beaufschlagt werden.

Bei dem Hohlraum mit dem kleineren Abstand gegenüberliegender Wandflächen kann auch der Abstand der Kontaktierungen etwas kleiner gewählt werden als bei dem Hohlraum mit dem größeren Abstand gegenüberliegender Wandflächen. Bei diesem Ausführungsbeispiel stellt insbesondere der niedrige, breit gezogene Hohlraum **71** eine Mischform dar, bei der die Vergrößerung des Volumens mit hoher Ionisationsdichte sowohl in als auch senkrecht zur Ausbreitungsrichtung der Sekundärelektronenkaskade erfolgt, da die Sekundärelektronenkaskade sich über die gesamte Breite des Hohlraumes 71 ausbreitenkann.

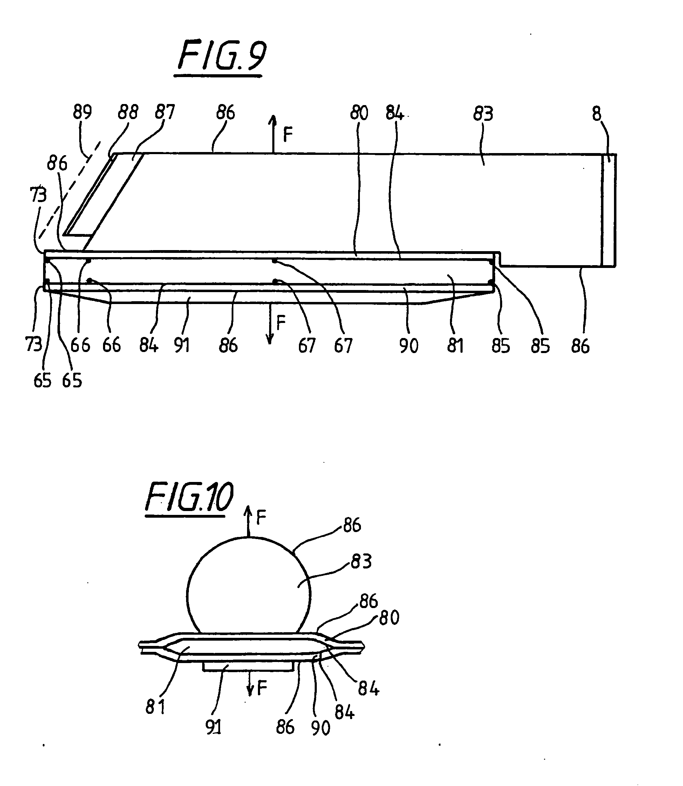

Eine weitere bevorzugte Ausführung der Erfindung besteht in der Verwendung eines Hohl- oder Zwischenraumes, dessen Wandflächen einen variierbaren Abstand haben, so dass der Abstand zwischen den Wandflächen auf den optimalen Wert für die Sekundärelektronenkaskade bei dem jeweiligen Kammerdruck eingestellt werden kann. Eine Schnittdarstellung eines solchen Ausführungsbeispiels ist in Figur 9 dargestellt. Ein weiterer Vorteil dieses Ausführungsbeispiels besteht darin, dass die Stirnfläche des Lichtleiters **83** mit einem Szintillator **87** versehen ist, auf dem eine Bedampfungsschicht **88** als dünne Kontaktierung aufgebracht ist, die beispielweise auf 10 kV liegt. Weiterhin ist ein Gitternetz **89** vor dieser Kontaktierung vorgesehen, um deren starkes elektrisches Feld gegenüber der Probenkammer abzuschwächen. Dieser Detektor kann auch bei Betrieb des Rasterelektronenmikroskops mit Hochvakuum in der Kammer als Everhardt-Thornley-Detektor verwendet werden. Der Vorteil besteht insbesondere darin, dass derselbe Lichtleiter **83** mit seiner in Figur 9 nicht dargestellten Vakuumdurchführung und derselbe Photonendetektor **82** sowohl bei Betrieb mit Vakuum in der Probenkammer als auch bei Betrieb mit Gas in der Probenkammer verwendet werden kann. Dasselbe Ausführungsbeispiel, das in der Figur 9 in einem Schnitt längs der Achse des Lichtleiters dargestellt ist, ist in Figur 10 in einem Schnitt quer zur Achse des Lichtleiters dargestellt. Es besteht aus einem Lichtleiter **83,** der mit dem Lichtleiter **80** verbunden ist, der an den Hohlraum **81** angrenzt, der den gegenüber der Probenkammer abgegrenzten Bereich darstellt, in dem das vergrößerte Volumen mit hoher Ionisationsdichte erzeugt wird. Im Gegensatz zum vorherigen Ausführungsbeispiel ist der Hohlraum **81** nach beiden Seiten geöffnet. Dies erfordert zwar eine größere Länge als ein nach nur einer Seite geöffneter Hohlraum, aber es hat den vorteil, dass die mechanische Herstellbarkeit des Abstandes gegenüber liegender Wände des Hohlraumes erleichtert wird. Die Verstellmöglichkeit hierfür ist durch zwei Pfeile **F** symbolisiert. Die Kraft greift dabei oben am Lichtleiter **83** bzw, unten an der Versteifung **91** an.

Je nach Abstand zwischen den sich gegenüberliegenden Wänden des Hohlraumes liegt an den Elektroden **65, 66, 67** entsprechend dem Ausführungsbeispiel in Figur 7 eine geeignete Potentialbeaufschlagung an, um im ersten Bereich des Hohlraumes zwischen den Elektroden **65,66** eine starke Sekundärelektronenkaskade zu erzeugen und im zweiten Bereich des Hohlraumes zwischen den Elektroden **66** und **67** eine hohe Ionisationsdichte aufrecht zu erhalten. Die Kontaktierung **85** liegt vorzugsweise auf dem Potential der Kontaktierung **65** oder auf dem Potential der Verspiegelung **86.** In dem Bereich zwischen den Kontaktierungen **67, 85** wird von der ausklingenden Sekundärelektronenkaskade auch noch ein Beitrag zum Photonensignal geliefert, der allerdings deutlich kleiner ist als das Photonensignal, das zwischen den Kontaktierungen **66** und **67** erzeugt wird. In diesem Ausführungsbeispiel ist es vorgesehen, dass der Hohlraum auch auf der unteren Seite durch den von außen verspiegelten Lichtleiter **90** begrenzt wird, auf den ebenso wie auf den oberen Lichtleiter **80** eine schwach leitfähige Schicht **84** aufgebracht ist. Stattdessen wäre es auch möglich, die untere Begrenzung **90** des Hohlraumes aus einem elektrisch nicht leitenden spiegelnden Material herzustellen und direkt hierauf die schwach leitfähige Beschichtung **84** aufzubringen.

## Patentansprüche

1. Rasterelektronenmi kroskop mit einer Probenhammer, geeignet für einen Betrieb mit Gas in der Probenkammer, mit einem Strahlführungsrohr für Primärelektronen, einem in der Probenkammer angeordneten Probenhalter, einer Druckstufenblende (21), durch die die Primärelektronen in die Probenkammer eintreten, und einer gegenüber dem Probenhalter und der Druckstufenblende (21) auf einem positiven Potential liegenden ersten Elektrode (51; 52) zur Beschleunigung von aus einer von dem Probenhalter aufzunehmenden Probe (11) austretenden Sekundärelektronen, wobei diese erste Elektrode (51; 52) außerhalb des Strahlführungsrohres angeordnet ist, und mit mindestens einer zweiten Elektrode (31), deren dem Probenhalter zugewandtes Ende vom Probenhalter weniger beabstandet ist als die erste Elektrode (51; 52) sowie auf einem Potential (U3) liegt, das zwischen dem Potential der ersten Elektrode(U6, U8) und dem Potential (U1) der Probe (11) oder auf dem Potential (U1) der Probe (11) liegt, **dadurch gekennzeichnet, dass** die zweite Elektrode (31) die erste Elektrode (51; 52) im wesentlichen trichterförmig mit der Trichterspitze zur Probe (11) umgibt.

2. Rasterelektronenmikroskop mit einer Probenhammer, geeignet für einen Betrieb mit Gas in der Probenkammer, mit einem Strahlführungsrohr für Primärelektronen, einem in der Probenkammer angeordneten Probenhalter, einer Druckstufenblende (21), durch die die Primärelektronen in die Probenkammer eintreten, und mit einer außerhalb des Strahlführungsrohrea angeordneten Elektrode (35; 54; 54a; 54b), zur Beschleunigung von aus einer von dem Probenhalter aufzunehmenen Probe austretenden Sekundär elektronen **dadurch gekennzeichnet, dass** diese Elektrode elektrisch gering leitfähig ist, so dass im Betrieb ein Potentialgefälle lüngs deren Oberfläche Stattfindet, und mindestens zwei Kontaktierungen aufweist, und dass das dem Probenhalter zugewandte Ende der elektrisch gering leitfähigen Elektrode auf einem elektrischen Potential (U3) liegt, das zwischen dem Potential der Kontaktierung mit höchstem Potential (U8) und dem Potential (U1) der Probe (11) oder auf dem Probenpotential (U1)liegt, wobei die Kontaktierung mit dem höchsten Potential (U8) gegenüber dem Probenhalter und der Druckstufenblende (21) auf einem positiven Potential liegt.

3. Rasterelektronenmikroskop nach Anspruch 1 oder 2, wobei Hilfselektroden 22, 34, 41, 42, 53, 54 zur Leitung der Sekundärelektronen zur ersten Elektrode vorgesehen sind.

4. Rasterelektronenmikroskop nach Anspruch 1 oder 3, soweit Anspruch 3 auf Anspruch 1 zurückbezogen ist, wobei die zweite Elektrode (30; 31) geneigt zur optischen Achse des Rasterelektronenmikroskops von der ersten Elektrode in Richtung auf den Probenhalter verläuft und an ihrem dem Probenhalter zugerichteten Ende eine Öffnung für einen Durchgriff des von der ersten Elektrode oder von den die Sekundärelektronen zur ersten Elektrode leitenden Hilfselektroden (34, 41 ; 53, 54) erzeugten Feldes bildet

5. Rasterelektronenmikroskop nach einem der Ansprüche 1 bis 4, wobei durch die zweite Elektrode (31) oder mit Hilfe des Potentialgefälles längs der Oberfläche der elektrisch gering leitfähigen Elektrode ein vergrößertes Volumen mit unterkritischer Ionisationsdichte erzeugt wird.

6. Rasterelektronenmikroskop nach Anspruch 5, wobei mehr als die Hälfte des vergrößerten Volumens
in einem Bereich liegt, der durch Elektroden von der restlichen Probenkammer abgegrenzt ist.

7. Rasterelektronenmikroskop nach einem der Ansprüche 1 bis 6, wobei die erste und die zweite Elektrode (31, 51, 52) oder die elektrisch gering leitfähige Elektrode (35, 54, 54a, 54b) rotationssymmetrisch zur optischen Achse des Rasterelektronenmikroskops ausgebildet sind.

8. Rasterelektronenmikroskop nach Anspruch 7, wobei die erste Elektrode (52) die optische Achse des Rasterelektronenmikroskops ringförmig umgibt und die zweite Elektrode (31) die erste Elektrode konisch auf den Probenhalter zulaufend umgibt.

9. Rasterelektronenmikroskop nach Anspruch 8, wobei eine Hilfselektrode ( 41) vorgesehen ist, die die optische Achse des Rasterelektronenmikroskops rohrförmig umgibt.

10. Rasterelektronenmikroskop nach Anspruch 2, wobei die elektrisch gering leitfähige Elektrode (54a, 54b) im Inneren eines zu einer Seite geöffneten Hohlraumes in einem Lichtleiter (56a - 56d) angebracht ist.

11. Rasterelektronenmikroskop nach Anspruch 10, wobei sich die gering leitfähige Elektrode (54a, 54b)auf der inneren Oberfläche des Lichtleiters (56a-56d) im Hohlraume erstreckt.

12. Rasterelektronenmikroskop nach Anspruch 10 oder 11, wobei der Hohlraum im Lichtleiter (56a-56d) pyramidenförmig ist.

13. Rasterelektronenmikroskop nach einem der Ansprüche 1 bis 12, wobei die erste Elektrode (51; 52), die am Ende der Sekundärelektronenkaskade angeordnet ist, auf einem Potential liegt, das um über 100 V, vorzugsweise über 200 V, positiv einstellbar ist gegenüber dem Potential der Druckstufenblende (21).

14. Rasterelektronenmikroskop nach Anspruch 13, wobei die erste Elektrode (51; 52), die am Ende der Sekundärelektronenkaskade angeordnet ist, auf einem Potential liegt, das um mindestens 550 V, vorzugsweise über 600 V positiv gegenüber der Probe (11) einstellbar ist.

15. Rasterelektronenmikroskop nach einem der Ansprüche 1 bis 14, wobei die zweite Elektrode (31) gegenüber der Probe auf einem Potential von mindestens 100 v einstellbar ist.

16. Rasterelektronenmikroskop nach einem der Ansprüche 1 bis 15, wobei eine auf der lichtdurchlässigen Oberfläche eines Lichtleiters (56) befestigte Elektrode (51, 52, 53, 54, 54a, 54b) aus mehreren Leiterbahnen oder Drähten aufgebaut ist, deren Breite weniger als 1 mm beträgt und zwischen denen Lücken vorhanden sind, durch die Photonen in den Lichtleiter eintreten können.

17. Rasterelektronenmikroskop nach einem der Ansprüche 1 bis 16, wobei auf der lichtdurchlässigen Oberfläche eines Lichtleiters (56) eine Elektrode (54, 54a, 54b) befestigt ist, längs der ein Potentialgefälle stattfindet und die entweder durchsichtig ist oder aus Strukturen besteht, deren Breite weniger als 1 mm beträgt und zwischen denen Lücken vorhanden sind, durch die die Photonen in den Lichtleiter eintreten können, wobei die Elektrode in beiden Fällen aus Material mit derart geringer Leitfähigkeit oder derart dünner Materialstärke besteht, dass das Potentialgefälle längs der Elektrode ermöglicht wird.

18. Detektor für aus einer Probe austretende Sekundärelektronen in einem Rasterelektronenmikroskop mit einer Probenkammer, geeignet für einen Betrieb mit Gas in der Probenkammer unter Ausnutzung einer Sekundärelektronenkaskade, **dadurch gekennzeichnet, dass** eine Elektrode (84) mit geringer elektrischer Leitfähigkeit vorgesehen ist, die sich entlang eines Zwischenraumes oder langgestreckten Hohlraumes (81) erstreckt, wobei die Elektrode (84) derart mit Potential beaufschlagbar ist, dass im Betrieb ein Potentialgefälle längs deren Oberfläche stattfindet und in einem eintrittsseitigen Bereich (68) innerhalb oder vor dem Hohl- oder Zwischenraum sich ein höherer Verstärkungsfaktor für Sekundärelektronen ergibt und sich an diesen eintrittsseitigen Bereich (68) ein langgestreckter Volumenbereich (69) mit einem reduzierten Verstärkungsfaktor für Sekundärelektronen anschließt.

19. Detektor für aus einer Probe austretende Sekundärelektronen in einem Rasterelektronenmikroskop mit einer Probenkammer, geeignet für einen Betrieb Gas in der Probenkammer unter Ausnutzung einer Sekundärelektronenkaskade, wobei mehrere Elektroden (65, 66, 67) vorgesehen sind, die sich entlang eines Zwischenraumes oder langgestreckten Hohlraumes (81) erstrecken, wobei die Elektroden (65) derart mit Potential beaufschlagbar sind, dass in einem eintrittsseitigen Bereich (68) innerhalb oder vor dem Hohl- oder Zwischenraum ein höherer Verstärkungsfaktor sich für Sekundärelektronen ergibt und sich an diesen eintrittsseitigen Bereich (68) ein langgestreckter Volumenbereich (69) mit einem reduzierten Verstärkungsfaktor für Sekundärelektronen anschließt, **dadurch gekennzeichnet, dass** die Potentialbeaufschlagung der Elektroden (66, 67) in diesem langgestreckten Volumenbereich derart erfolgt, dass das anliegende elektrische Feld der durch Stöße im Gas und durch Driften der Sekundärelektronen zu den Wänden auftretenden Schwächung der Sekundärelektronenkaskade entgegenwirkt, so dass eine unterkritische Ionisationsdichte aufrecht erhalten bleibt, und wobei der Detektor mit Mitteln zur Nachweisung von langgestreckten Volumenbereich erzeugten Photonen ausgestattet ist.

20. Detektor nach Anspruch 18 oder 19, wobei der Hohlraum in einem Lichtleiter (83) gebildet ist oder an einen Lichtleiter (83) angrenzt und der Lichtleiter (83) zum Nachweis von Gasszintillation ausgebildet ist.

21. Detektor nach Anspruch 20, wobei die Elektrode oder Elektroden (84, 66, 67) lichtdurchlässig sind oder aus Strukturen mit Zwischenräumen für einen Lichtdurchtritt bestehen.

22. Detektor nach einem der Ansprüche 18 bis 21, wobei das Potential der Elektrode (84) oder Elektroden (66, 67) in dem Hohl- oder Zwischenraum (81) stellenweise mindestens 200 V, vorzugsweise größer als 400 V, positiv gegenüber einer der Probe zugewandten Druckstufenblende (21) des Rasterelektronenmikroskops, durch die Primärelektronen in die Probekammer eintreten, einsteelbar ist.

23. Detektor nach einem der Ansprüche 18 bis 22, wobei das Potential der Elektrode (84) oder Elektroden (66, 67) in dem Hohl- oder zwischenraum (81) stellenweise mehr als 600 V positiv gegenüber der die Sekundärelektronen emittierenden Probe einstellbar ist.

24. Detektor nach einem der Ansprüche 18 bis 23, wobei der langgestreckte Volumenbereich (69) in Längsrichtung
größer ist als das Doppelte des größten Durchmessers eines in den Querschnitt des Hohl- oder Zwischenraumes (81) einschreibbaren Kreises.

25. Detektor nach einem der Ansprüche 18 bis 24, wobei der reduzierte Verstärkungsfaktor kleiner als 5-fach, vorzugsweise kleiner als 2-fach, einstellbar ist.

26. Detektor nach Anspruch 25, wobei der reduzierte verstärkungsfaktor größer als 0,2-fach einstellbar ist.

## Claims

1. Scanning electron microscope comprising a sample chamber, suitable for operation with gas in the sample chamber, comprising a beam guiding tube for primary electrons, a sample holder arranged in the sample chamber, a pressure stage aperture (21), through which the primary electrons enter into the sample chamber, and a first electrode (51; 52), which is at a positive potential relative to the sample holder and the pressure stage aperture (21) and serves for accelerating secondary electrons emerging from a sample (11) to be received by the sample holder, wherein said first electrode (51; 52) is arranged outside the beam guiding tube, and comprising at least one second electrode (31) whose end facing the sample holder is at a lesser distance from the sample holder than the first electrode (51, 52) and is at a potential (U3) which is between the potential of the first electrode (U6, U8) and the potential (U1) of the sample (11) or is at the potential (U1) of the sample (11), **characterized in that** the second electrode (31) surrounds the first electrode (51; 52) substantially in a funnel-shaped manner with the funnel tip towards the sample (11).

2. Scanning electron microscope comprising a sample chamber, suitable for operation with gas in the sample chamber, comprising a beam guiding tube for primary electrons, a sample holder arranged in the sample chamber, a pressure stage aperture (21), through which the primary electrons enter into the sample chamber, and comprising an electrode (35; 54; 54a; 54b) arranged outside the beam guiding tube and serving for accelerating secondary electrons emerging from a sample to be received by the sample holder, **characterized in that** said electrode has low electrical conductivity, such that a potential gradient occurs along its surface during operation, and has at least two contact-connections, and **in that** that end of the electrode having low electrical conductivity which faces the sample holder is at an electrical potential (U3) that is between the potential of the contact-connection having the highest potential (U8) and the potential (U1) of the sample (11) or is at the sample potential (U1), wherein the contact-connection having the highest potential (U8) is at a positive potential relative to the sample holder and the pressure stage aperture (21).

3. Scanning electron microscope according to Claim 1 or 2, wherein auxiliary electrodes (22, 34, 41, 42, 53, 54) for conducting the secondary electrons to the first electrode are provided.

4. Scanning electron microscope according to Claim 1 or 3, in so far as Claim 3 refers back to Claim 1, wherein the second electrode (30; 31) runs at an inclination with respect to the optical axis of the scanning electron microscope from the first electrode in the direction of the sample holder and, at its end facing the sample holder, forms an opening for penetration of the field generated by the first electrode or by the auxiliary electrodes (34, 41; 53, 54) conducting the secondary electrons to the first electrode.

5. Scanning electron microscope according to any of Claims 1 to 4, wherein an increased volume with subcritical ionization density is produced by the second electrode (31) or with the aid of the potential gradient along the surface of the electrode having low electrical conductivity.

6. Scanning electron microscope according to Claim 5, wherein more than half of the increased volume lies in a region which is delimited from the rest of the sample chamber by electrodes.

7. Scanning electron microscope according to any of Claims 1 to 6, wherein the first and second electrodes (31, 51, 52) or the electrode (35, 54, 54a, 54b) having low electrical conductivity are/is embodied as rotationally symmetrical with respect to the optical axis of the scanning electron microscope.

8. Scanning electron microscope according to Claim 7, wherein the first electrode (52) surrounds the optical axis of the scanning electron microscope in a ringshaped manner and the second electrode (31) surrounds the first electrode in a manner tapering conically towards the sample holder.

9. Scanning electron microscope according to Claim 8, wherein an auxiliary electrode (41) is provided which surrounds the optical axis of the scanning electron microscope in a tubular manner.

10. Scanning electron microscope according to Claim 2, wherein the electrode (54a, 54b) having low electrical conductivity is fitted in the interior of a cavity open to one side in an optical waveguide (56a - 56d).

11. Scanning electron microscope according to Claim 10, wherein the electrode (54a, 54b) having low conductivity extends on the inner surface of the optical waveguide (56a - 56d) in the cavity.

12. Scanning electron microscope according to Claim 10 or 11, wherein the cavity in the optical waveguide (56a - 56d) is pyramidal.

13. Scanning electron microscope according to any of Claims 1 to 12, wherein the first electrode (51; 52), which is arranged at the end of the secondary electron cascade, is at a potential that is adjustable by more than 100 V, preferably more than 200 V, in positive fashion relative to the potential of the pressure stage aperture (21).

14. Scanning electron microscope according to Claim 13, wherein the first electrode (51; 52), which is arranged at the end of the secondary electron cascade, is at a potential that is adjustable by at least 550 V, preferably more than 600 V, in positive fashion relative to the sample (11).

15. Scanning electron microscope according to any of Claims 1 to 14, wherein the second electrode (31) is adjustable to a potential of at least 100 V relative to the sample.

16. Scanning electron microscope according to any of Claims 1 to 15, wherein an electrode (51, 52, 53, 54, 54a, 54b) fixed on the light-transmissive surface of an optical waveguide (56) is constructed from a plurality of conductor tracks or wires, the width of which is less than 1 mm and between which gaps are present through which photons can enter into the optical waveguide.

17. Scanning electron microscope according to any of Claims 1 to 16, wherein an electrode (54, 54a, 54b) is fixed on the light-transmissive surface of an optical waveguide (56), along which electrode a potential gradient occurs and which electrode either is transparent or consists of structures, the width of which is less than 1 mm and between which gaps are present through which the photons can enter into the optical waveguide, wherein the electrode in both cases consists of material having such low conductivity or such thin material thickness that the potential gradient along the electrode is made possible.

18. Detector for secondary electrons emerging from a sample in a scanning electron microscope comprising a sample chamber, suitable for operation with gas in the sample chamber with the use of a secondary electron cascade, **characterized in that** an electrode (84) having low electrical conductivity is provided, which extends along an interspace or elongated cavity (81), wherein potential can be applied to the electrode (84) in such a way that a potential gradient occurs along the surface of said electrode during operation and a higher gain factor for secondary electrons arises in an entrance-side region (68) within or before the cavity or interspace and an elongated volume region (69) having a reduced gain factor for secondary electrons follows said entrance-side region (68).

19. Detector for secondary electrons emerging from a sample in a scanning electron microscope comprising a sample chamber, suitable for operation with gas in the sample chamber with the use of a secondary electron cascade, wherein a plurality of electrodes (65, 66, 67) are provided, which extend along an interspace or elongated cavity (81), wherein potential can be applied to the electrodes (65) in such a way that a higher gain factor for secondary electrons arises in an entrance-side region (68) within or before the cavity or interspace and an elongated volume region (69) having a reduced gain factor for secondary electrons follows said entrance-side region (68), **characterized in that** potential is applied to the electrodes (66, 67) in said elongated volume region in such a way that the electrical field present counteracts the attenuation of the secondary electron cascade that occurs as a result of collisions in the gas and as a result of drift of the secondary electrons with respect to the walls, such that a subcritical ionization density is maintained, and wherein the detector is equipped with means for detecting photons generated in the elongated volume region.

20. Detector according to Claim 18 or 19, wherein the cavity is formed in an optical waveguide (83) or adjoins an optical waveguide (83) and the optical waveguide (83) is designed for detecting gas scintillation.

21. Detector according to Claim 20, wherein the electrode or electrodes (84, 66, 67) is/are light-transmissive or consist(s) of structures with interspaces for passage of light.

22. Detector according to any of Claims 18 to 21, wherein the potential of the electrode (84) or electrodes (66, 67) in the cavity or interspace (81) is adjustable in places at least 200 V, preferably greater than 400 V, in positive fashion relative to a pressure stage aperture (21) of the scanning electron microscope, said pressure stage aperture facing the sample and primary electrons entering into the sample chamber through said pressure stage aperture.

23. Detector according to any of Claims 18 to 22, wherein the potential of the electrode (84) or electrodes (66, 67) in the cavity or interspace (81) is adjustable in places more than 600 V in positive fashion relative to the sample that emits the secondary electrons.

24. Detector according to any of Claims 18 to 23, wherein the elongated volume region (69) is larger in the longitudinal direction than double the largest diameter of a circle inscribable into the cross section of the cavity or interspace (81).

25. Detector according to any of Claims 18 to 24, wherein the reduced gain factor is adjustable to be less than 5-fold, preferably less than 2-fold.

26. Detector according to Claim 25, wherein the reduced gain factor is adjustable to be greater than 0.2-fold.

## Revendications

1. Microscope électronique à balayage comprenant une chambre à échantillon, conçu pour un fonctionnement avec du gaz dans la chambre à échantillon, comprenant un tube de positionnement de faisceau pour les électrons primaires, un porte-échantillon disposé dans la chambre à échantillon, un obturateur d'étage de pression (21) à travers lequel les électrons primaires pénètrent dans la chambre à échantillon, et une première électrode (51 ; 52), qui se trouve à un potentiel positif par rapport au porte-échantillon et à l'obturateur d'étage de pression (21), pour accélérer les électrons secondaires qui sortent d'un échantillon (11) à accueillir par le porte-échantillon, cette première électrode (51 ; 52) étant disposée à l'extérieur du tube de positionnement de faisceau, et comprenant au moins une deuxième électrode (31) dont l'extrémité qui fait face au porte-échantillon est moins éloignée du porte-échantillon que la première électrode (51 ; 52) et qui se trouve à un potentiel (U3) qui est compris entre le potentiel de la première électrode (U6, U8) et le potentiel (U1) de l'échantillon (11) ou au potentiel (U1) de l'échantillon (11), **caractérisé en ce que** la deuxième électrode (31) entoure la première électrode (51 ; 52) essentiellement à la manière d'un entonnoir, avec la pointe de l'entonnoir vers l'échantillon (11).

2. Microscope électronique à balayage comprenant une chambre à échantillon, conçu pour un fonctionnement avec du gaz dans la chambre à échantillon, comprenant un tube de positionnement de faisceau pour les électrons primaires, un porte-échantillon disposé dans la chambre à échantillon, un obturateur d'étage de pression (21) à travers lequel les électrons primaires pénètrent dans la chambre à échantillon, et une électrode (35 ; 54 ; 54a ; 54b) disposée à l'extérieur du tube de positionnement de faisceau pour accélérer les électrons secondaires qui sortent d'un échantillon à accueillir par le porte-échantillon, **caractérisé en ce que** cette électrode est faiblement conductrice d'électricité, de sorte qu'il se produit, en fonctionnement, un gradient de potentiel le long de sa surface, et présente au moins deux points de contact, et **en ce que** l'extrémité de l'électrode faiblement conductrice d'électricité qui fait face au porte-échantillon se trouve à un potentiel électrique (U3) qui est compris entre le potentiel du point de contact ayant le potentiel le plus élevé (U8) et le potentiel (U1) de l'échantillon (11) ou au potentiel de l'échantillon (U1), le point de contact ayant le potentiel le plus élevé (U8) se trouvant à un potentiel positif par rapport au porte-échantillon et à l'obturateur d'étage de pression (21).

3. Microscope électronique à balayage selon la revendication 1 ou 2, dans lequel sont prévues des électrodes auxiliaires (22, 34, 41, 42, 53, 54) pour conduire les électrons secondaires vers la première électrode.

4. Microscope électronique à balayage selon la revendication 1 ou 3, sous réserve que la revendication 3 se rapporte à la revendication 1, dans lequel la deuxième électrode (30 ; 31) s'étend en étant inclinée par rapport à l'axe optique du microscope électronique à balayage de la première électrode en direction du porte-échantillon et forme à son extrémité dirigée vers le porte-échantillon une ouverture pour une pénétration du champ généré par la première électrode ou par les électrodes auxiliaires (34, 41 ; 53, 54) conduisant les électrons secondaires vers la première électrode.

5. Microscope électronique à balayage selon l'une des revendications 1 à 4, dans lequel un volume agrandi ayant une densité d'ionisation sous-critique est généré par la deuxième électrode (31) ou à l'aide du gradient de potentiel le long de la surface de l'électrode faiblement conductrice d'électricité.

6. Microscope électronique à balayage selon la revendication 5, dans lequel plus de la moitié du volume agrandi se trouve dans une plage qui est délimitée par les électrodes du reste de la chambre à échantillon.

7. Microscope électronique à balayage selon l'une des revendications 1 à 6, dans lequel la première et la deuxième électrode (31, 51, 52) ou l'électrode faiblement conductrice d'électricité (35, 54, 54a, 54b) sont configurées avec une symétrie rotationnelle par rapport à l'axe optique du microscope électronique à balayage.

8. Microscope électronique à balayage selon la revendication 7, dans lequel la première électrode (52) entoure de manière annulaire l'axe optique du microscope électronique à balayage et la deuxième électrode (31) entoure la première électrode de manière conique en se rétrécissant vers le porte-échantillon.

9. Microscope électronique à balayage selon la revendication 8, dans lequel il est prévu une électrode auxiliaire (41) qui entoure de manière tubulaire l'axe optique du microscope électronique à balayage.

10. Microscope électronique à balayage selon la revendication 2, dans lequel l'électrode faiblement conductrice d'électricité (54a, 54b) est montée à l'intérieur d'un espace creux ouvert vers un côté dans un guide de lumière (56a - 56d).

11. Microscope électronique à balayage selon la revendication 10, dans lequel l'électrode faiblement conductrice d'électricité (54a, 54b) s'étend sur la surface intérieure du guide de lumière (56a - 56d).

12. Microscope électronique à balayage selon la revendication 10 ou 11, dans lequel l'espace creux dans le guide de lumière (56a - 56d) est de forme pyramidale.

13. Microscope électronique à balayage selon l'une des revendications 1 à 12, dans lequel la première électrode (51 ; 52), qui est disposée à la fin de la cascade d'électrons secondaires, se trouve à un potentiel qui est réglable positivement à plus de 100 V, de préférence à plus de 200 V, par rapport au potentiel de l'obturateur d'étage de pression (21).

14. Microscope électronique à balayage selon la revendication 13, dans lequel la première électrode (51 ; 52), qui est disposée à la fin de la cascade d'électrons secondaires, se trouve à un potentiel qui est réglable positivement à au moins 550 V, de préférence à plus de 600 V, par rapport à l'échantillon (11).

15. Microscope électronique à balayage selon l'une des revendications 1 à 14, dans lequel la deuxième électrode (31) est réglable à un potentiel d'au moins 100 V par rapport à l'échantillon.

16. Microscope électronique à balayage selon l'une des revendications 1 à 15, dans lequel une électrode (51, 52, 53, 54, 54a, 54b) fixée sur la surface laissant passer la lumière d'un guide de lumière (56) est constituée de plusieurs pistes conductrices ou fils métalliques dont la largeur est inférieure à 1 mm et entre lesquels se trouvent des interstices à travers lesquels les photons peuvent pénétrer dans le guide de lumière.

17. Microscope électronique à balayage selon l'une des revendications 1 à 16, dans lequel une électrode (54, 54a, 54b) est fixée sur la surface laissant passer la lumière d'un guide de lumière (56), le long de laquelle se produit un gradient de potentiel et laquelle est soit transparente, soit se compose de structures dont la largeur est inférieure à 1 mm et entre lesquelles se trouvent des interstices à travers lesquels les photons peuvent pénétrer dans le guide de lumière, l'électrode se composant dans les deux cas d'un matériau ayant une conductivité réduite ou une épaisseur de matériau plus mince de telle sorte que le gradient de potentiel le long de l'électrode est rendu possible.

18. Détecteur pour les électrons secondaires sortant d'un échantillon dans un microscope électronique à balayage comprenant une chambre à échantillon, conçu pour un fonctionnement avec du gaz dans la chambre à échantillon en utilisant une cascade d'électrons secondaires, **caractérisé en ce qu'**il est prévu une électrode (84) ayant une faible conductivité d'électricité qui s'étend le long d'un espace intermédiaire ou d'un espace creux (81) étendu en longueur, l'électrode (84) pouvant être exposée à un potentiel de telle sorte qu'il se produit, en fonctionnement, un gradient de potentiel le long de sa surface et, dans une zone (68) du côté de l'entrée à l'intérieur de ou avant l'espace creux ou l'espace intermédiaire, il se produit un facteur d'amplification plus élevé pour les électrons secondaires, et une zone de volume (69) étendue en longueur ayant un facteur d'amplification réduit pour les électrons secondaires vient se rattacher à cette zone (68) du côté de l'entrée.

19. Détecteur pour les électrons secondaires sortant d'un échantillon dans un microscope électronique à balayage comprenant une chambre à échantillon, conçu pour un fonctionnement avec du gaz dans la chambre à échantillon en utilisant une cascade d'électrons secondaires, dans lequel plusieurs électrodes (65, 66, 67) sont prévues, lesquelles s'étendent le long d'un espace intermédiaire ou d'un espace creux (81) étendu en longueur, les électrodes (65) pouvant être exposées à un potentiel de telle sorte qu'il se produit dans une zone (68) du côté de l'entrée à l'intérieur de ou avant l'espace creux ou l'espace intermédiaire, un facteur d'amplification plus élevé pour les électrons secondaires, et une zone de volume (69) étendue en longueur ayant un facteur d'amplification réduit pour les électrons secondaires vient se rattacher à cette zone (68) du côté de l'entrée, **caractérisé en ce que** l'exposition des électrodes (66, 67) au potentiel dans cette zone de volume étendue en longueur s'effectue de telle sorte que le champ électrique appliqué s'oppose à l'affaiblissement de la cascade d'électrons secondaires qui se produit en raison des chocs dans le gaz et des dérives des électrons secondaires par rapport aux parois, ce qui permet de maintenir une densité d'ionisation sous-critique, et le détecteur étant équipé de moyens pour déceler les photons générés dans la zone de volume étendue en longueur.

20. Détecteur selon la revendication 18 ou 19, dans lequel l'espace creux est formé dans un guide de lumière (83) ou est juxtaposé à un guide de lumière (83) et le guide de lumière (83) est configuré pour déceler la scintillation du gaz.

21. Détecteur selon la revendication 20_{,} dans lequel l'électrode ou les électrodes (84, 66, 67) laissent passer la lumière ou se composent de structures munies d'espaces intermédiaires pour un passage de la lumière.

22. Détecteur selon l'une des revendications 18 à 21, dans lequel le potentiel de l'électrode (84) ou des électrodes (66, 67) dans l'espace intermédiaire ou l'espace creux (81) est réglable partiellement au moins à 200 V, de préférence à plus de 400 V positivement par rapport à un obturateur d'étage de pression (21) du microscope électronique à balayage qui fait face à l'échantillon et à travers lequel les électrons primaires pénètrent dans la chambre à échantillon.

23. Détecteur selon l'une des revendications 18 à 22, dans lequel le potentiel de l'électrode (84) ou des électrodes (66, 67) dans l'espace intermédiaire ou l'espace creux (81) est réglable partiellement à plus de 600 V positivement par rapport à l'échantillon émettant les électrons secondaires.

24. Détecteur selon l'une des revendications 18 à 23, dans lequel la zone de volume (69) étendue en longueur est plus grand dans le sens de la longueur que le double du plus grand diamètre d'un cercle qui peut être inscrit dans la section transversale de l'espace intermédiaire ou de l'espace creux (81).

25. Détecteur selon l'une des revendications 18 à 24, dans lequel le facteur d'amplification réduit est réglable à moins de 5 fois, de préférence à moins de 2 fois.

26. Détecteur selon la revendication 25, dans lequel le facteur d'amplification réduit est réglable à plus de 0,2 fois.
